Europäisches Patentamt

European Patent Office

Office européen des brevets

(19)

(11) Numéro de publication : **0 595 710 A1**

# (12) DEMANDE DE BREVET EUROPEEN

(21) Numéro de dépôt : **93402625.3**

(22) Date de dépôt : **26.10.93**

(51) Int. Cl.$^5$ : **H03H 17/02**

(30) Priorité : **29.10.92 FR 9212930**

(43) Date de publication de la demande :
**04.05.94 Bulletin 94/18**

(84) Etats contractants désignés :
**DE FR GB IT NL**

(71) Demandeur : **FRANCE TELECOM**
**6, Place d'Alleray**
**F-75015 Paris (FR)**

(71) Demandeur : **TELEDIFFUSION DE FRANCE**
**10, rue d'Oradour sur Glane**
**F-75015 Paris (FR)**

(72) Inventeur : **Mau, Joel**
**146 bis, rue de Fougères**
**F-35000 Rennes (FR)**
Inventeur : **Soyer, Patrice**
**13 square René Coty**
**F-35000 Rennes (FR)**

(74) Mandataire : **Fréchède, Michel et al**
**Cabinet Plasseraud 84, rue d'Amsterdam**
**F-75440 Paris Cédex 09 (FR)**

(54) **Procédé et dispositif de segmentation en sous-bandes et de reconstruction d'un signal numérique, et dispositif correspondant.**

(57) Le procédé de segmentation en sous-bandes, du type consistant à soumettre chaque échantillon E(n) à un traitement en parallèle sur une pluralité de voies par filtrage prototype modulé par une fonction périodique et sous-échantillonnage par le nombre de sous-bandes, consiste à effectuer en combinaison un filtrage (1), (2) de type polyphase modifié et un traitement par transformée fréquentielle (2), (1), ce qui permet de délivrer un signal en sous-bande Xk pour chaque voie de rang correspondant. La reconstruction comprend en combinaison les étapes duales (2), (1) fréquentielle et de filtrage polyphase modifié (1), (2) pour délivrer le signal numérique reconstruit Rec(n).

Ces modules correspondants de traitement par transformée fréquentielle et de filtrage polyphase modifié sont réalisés au moyen de filtres MOT ou PRMF.

Application à tout type de signaux numériques, notamment d'image de télévision.

FIG. 2a.

L'invention concerne un procédé et un dispositif de segmentation en sous-bandes et de reconstruction d'un signal numérique.

A l'heure actuelle, il existe plusieurs techniques de décomposition ou transformation de signaux numériques, du domaine temporel dans le domaine fréquentiel, et de transformation inverse associée correspondante. Parmi les plus connues, on peut citer la transformée en cosinus discrète, ou DCT, la transformée de Fourier rapide, FFT, ou la transformation de Karhunen-Loeve. En outre, certaines techniques sont plus spécifiques à la décomposition en sous-bandes et à la reconstruction correspondante, ces techniques étant plus particulièrement basées sur l'utilisation des filtres conjugués en quadrature ou CQF (Conjugate Quadrature Filters), des filtres miroirs en quadrature ou QMF (Quadrature Mirror Filters) et des filtres miroirs en pseudo-quadrature ou PQMF (Pseudo Quadrature Mirror Filters), selon le vocable anglo-saxon.

D'une manière générale, ces techniques de transformation et de reconstruction sont utilisées par exemple dans le but d'effectuer un codage à réduction de débit de signaux numériques, rendu possible par la concentration de l'information utile sur un nombre réduit de coefficients décorrélés entre eux, lesquels sont alors seuls transmis.

Ces techniques sont utilisables et utilisées pour la transmission de signaux audio- ou vidéo-numériques par exemple.

Toutefois, les techniques précitées autres que les procédés de segmentation en sous-bandes, appliquées à la transmission de signaux vidéo-numériques, présentent l'inconvénient d'appliquer un jeu de coefficients sur un bloc de pixels, sans aucunement tenir compte des blocs adjacents. Un tel manquement a pour effet, lors du processus de reconstruction du signal d'origine après transmission, d'engendrer des phénomènes d'effets de blocs d'autant plus visibles que le nombre de coefficients utiles, issus de la transformation, est réduit.

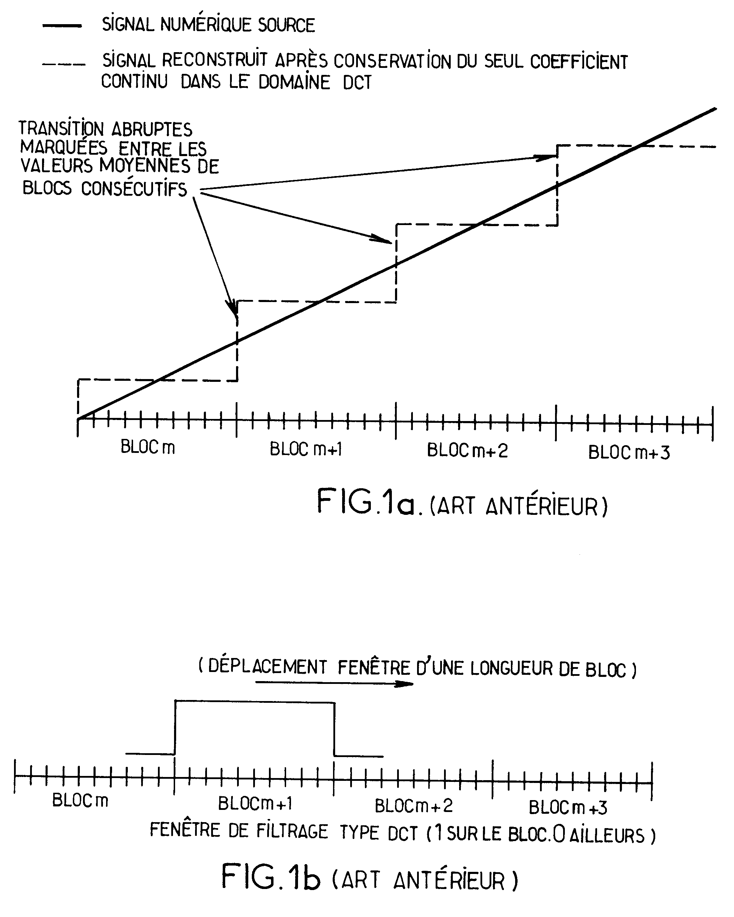

On peut citer à titre illustratif, ainsi que représenté en figure la, l'exemple d'une transformée DCT appliquée à un signal numérique, fonction linéaire du rang de chaque bloc, dont on ne conserve que le coefficient (ou composante) continu dans le domaine fréquentiel, suite à la transformée opérée. Le signal engendré après reconstruction se présente alors sous la forme d'une fonction en marche d'escalier, dont la longueur des paliers est égale à la dimension de la transformée DCT utilisée. Une telle fonction met particulièrement en évidence les effets de blocs inhérents à l'utilisation, pour la mise en oeuvre de ce type de transformée, de fenêtres de pondération ou de filtrage de type ET logique [1,0] sur la longueur de chaque bloc, ainsi que représenté en figure 1b.

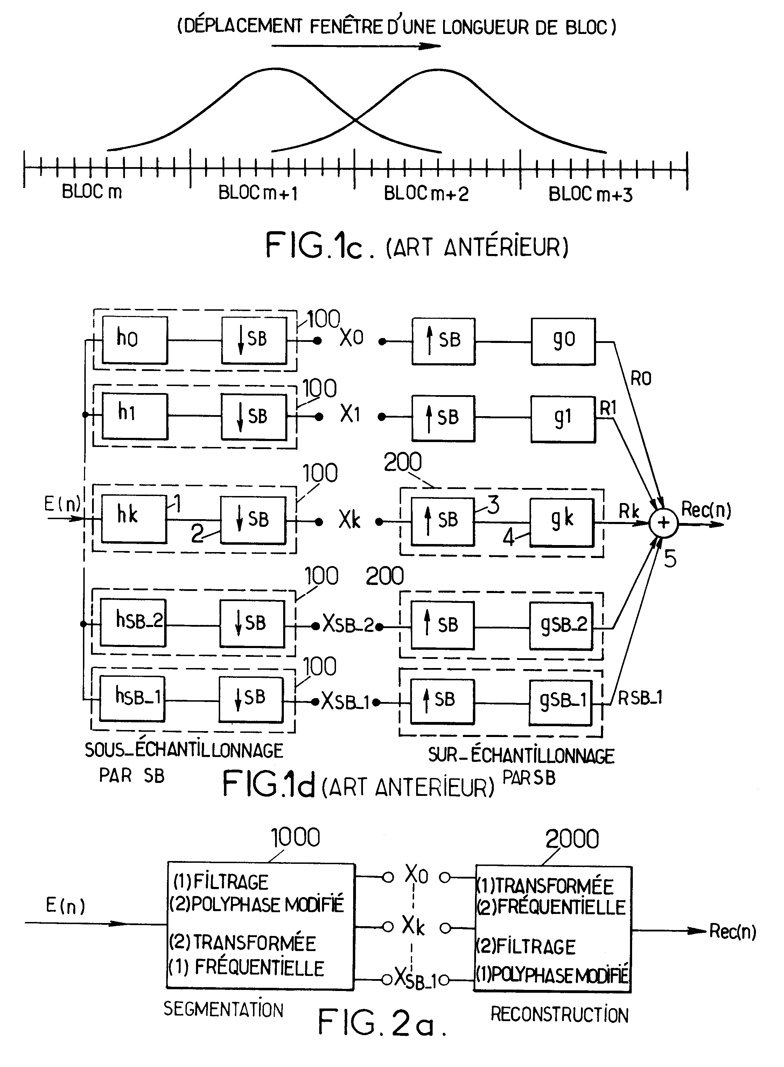

L'élimination de l'effet de blocs précité a été rendue possible grâce à la mise en oeuvre des procédés de décomposition-reconstruction en sous-bandes utilisant des fenêtres de filtrage au profil plus doux et de largeur supérieure à la longueur des blocs, telles que représentées en figure 1c, et tirant de ce fait mieux partie des corrélations entre blocs voisins.

En ce qui concerne les procédés de filtrage en sous-bandes mis en oeuvre à partir de structures en cascade à base de filtres CQF ou QMF, l'obtention d'une reconstruction quasi-parfaite et la mise en jeu d'un nombre conséquent de sous-bandes ont conduit à l'utilisation de filtres relativement longs, nécessitant des temps de calcul prohibitifs.

Dans le cas, au contraire, des transformations mettant en oeuvre des bancs de filtres PQMF engendrant des sous-bandes en parallèle, bien que les coûts de calcul nécessaires ne soient pas aussi importants, la longueur des filtres est par contre importante, au moins égale à huit fois le nombre de sous-bandes de segmentation, dès lors que, moyennant cependant certaines approximations, l'on recherche des conditions de reconstruction presque parfaites du signal d'origine. L'usage de filtres PQMF à 64 coefficients est ainsi fréquent pour la décomposition puis la reconstruction d'un signal numérique en huit sous-bandes, les filtres utilisés pour ce type de transformation étant le plus souvent constitués d'un nombre pair de coefficients, multiples pairs du nombre de sous-bandes SB.

D'une manière générale, ainsi qu'on l'a représenté en figure 1d, un dispositif de segmentation en sous-bandes de type classique comprend une pluralité SB de voies en parallèle recevant chacune les échantillons $E(n)$ du signal numérique d'entrée. Chacune des voies correspond à une sous-bande et comporte un filtre numérique en sous-bande, noté 100-1, pour la voie ou la sous-bande de rang k correspondant. Ce filtre numérique est formé par exemple par un filtre prototype de type passe-bas, modulé par une fonction périodique. On notera toutefois que le filtre prototype de type passe-bas de fonction de transfert $h(n)$ peut être remplacé par un filtre passe-haut de fonction de transfert $(-1)^n \cdot h(n)$. Il est suivi d'un circuit sous-échantillonneur, noté 100-2, ce circuit effectuant un sous-échantillonnage par le nombre SB de sous-bandes ou de voies de façon à délivrer un signal en sous-bande $X_k$ pour chaque voie de rang k correspondant.

On comprend bien sûr que chaque voie comporte ainsi un filtre numérique suivi d'un circuit sous-échantillonneur pour délivrer un signal en sous-bande de rang k correspondant.

De la même manière, ainsi qu'on l'a également représenté en figure 1d, un dispositif de reconstruction d'un signal numérique en sous-bandes de type classique, ce signal correspondant à une pluralité SB de si-

gnaux en sous-bandes $X_k$ délivrés en parallèle à la suite d'une segmentation antérieure en sous-bandes d'un signal numérique E(n) d'entrée, comprend une pluralité SB de voies de traitement en parallèle, chaque voie en parallèle, pour un signal en sous-bande $X_k$ considéré, comportant un circuit de suréchantillonnage par le nombre SB de signaux en sous-bandes, ce circuit étant suivi d'un circuit de filtrage numérique en sous-bande. Ce circuit est formé d'un filtre prototype de type passe-bas modulé par une fonction périodique pour délivrer une composante de sous-bande, notée $R_k$ du signal numérique reconstruit, obtenu par sommation des composantes.

La présente invention a pour objet de remédier aux inconvénients précités des techniques antérieures.

Un autre objet de la présente invention est en conséquence la mise en oeuvre d'un procédé et un dispositif de segmentation en sous-bandes et de reconstruction d'un signal numérique permettant une reconstruction parfaite ou presque parfaite grâce à l'utilisation de bancs de filtres PRMF (Perfect Reconstruction Modulated Filter banks) respectivement CPRMF (Close to Perfect Reconstruction Modulated Filterbanks) en vocable anglo-saxon, ces filtres pouvant présenter une longueur très courte, paire ou impaire.

Un autre objet de la présente invention est également la mise en oeuvre d'un procédé et d'un dispositif de segmentation en sous-bandes et de reconstruction d'un signal numérique, constituant une amélioration sensible des techniques de l'art antérieur basées sur l'utilisation des filtres modulés PQMF, dans la mesure où, grâce à la mise en oeuvre précitée, des filtres plus courts permettent d'effectuer une segmentation en un même nombre de sous-bandes et une reconstruction parfaite du signal numérique.

Un autre objet de la présente invention est également la mise en oeuvre d'un procédé et d'un dispositif de segmentation en sous-bandes et de reconstruction basés sur un processus de traitement rapide pour chaque opération de segmentation respectivement de reconstruction, ce processus de traitement, de structure régulière, permettant de minimiser le nombre d'opérations requises.

Un autre objet de la présente invention est en outre, grâce notamment aux propriétés du processus de traitement précité, la mise en oeuvre de modules de traitement correspondants sous forme de circuit intégré, nécessitant une taille mémoire minimum.

Un autre objet de la présente invention est également la mise en oeuvre d'un dispositif de segmentation en sous-bandes et de reconstruction d'un signal numérique présentant, de ce fait, une structure modulaire, pouvant, le cas échéant, faire appel à l'utilisation de certains éléments ou modules déjà disponibles dans le commerce.

Le procédé de segmentation en sous-bandes d'un signal numérique, constitué par une suite d'échantillons numériques, objet de la présente invention, procédé du type consistant à soumettre chaque échantillon à un traitement en parallèle sur une pluralité de voies de façon à décomposer ce signal numérique en un nombre correspondant de sous-bandes, ce traitement, pour chaque sous-bande, consistant à effectuer un filtrage prototype modulé par une fonction périodique et un sous-échantillonnage par le nombre de sous-bandes pour délivrer un signal en sous-bandes $X_k$ pour chaque voie de rang k correspondant, est remarquable en ce qu'il consiste, pour une succession de blocs d'échantillons formés par N échantillons formant le signal numérique, à effectuer, au moyen d'un filtrage prototype de type passe-bas à deux composantes, une composante symétrique et une composante antisymétrique, chacune modulée par une fonction périodique, en combinaison, un filtrage et un traitement par transformée fréquentielle du signal numérique, ce filtrage correspondant à un filtrage polyphase modifié, ce qui permet de délivrer un signal en sous-bande $X_k$ pour chaque voie de rang k correspondant.

Le procédé de reconstruction d'un signal numérique en sous-bandes, objet de la présente invention, ce signal correspondant à une pluralité de signaux en sous-bandes $X_k$, délivrés en parallèle suite à une segmentation en sous-bandes d'un signal numérique E(n), ce procédé de reconstruction du type consistant à soumettre chaque signal en sous-bandes $X_k$ à un traitement en parallèle comportant un suréchantillonnage par le nombre de signaux en sous-bandes et un filtrage numérique au moyen d'un filtrage prototype de type passe-bas modulé par une fonction périodique pour délivrer une composante de sous-bandes $R_k$ de signal numérique reconstruit, puis une sommation synchrone des composantes de sous-bandes de signal numérique reconstruit pour engendrer le signal numérique reconstruit Rec(n), est remarquable en ce qu'il consiste, pour une pluralité de signaux en sous-bandes $X_k$, à effectuer, au moyen d'un filtrage prototype de type passe-bas à deux composantes, une composante symétrique et une composante antisymétrique, chacune modulée par une fonction périodique, en combinaison, un traitement par transformée fréquentielle de signaux en sous-bandes et un filtrage, ce traitement par filtrage correspondant à un traitement de filtrage de type polyphase modifié, ce qui permet de délivrer le signal numérique reconstruit.

Le dispositif de segmentation en sous-bandes d'un signal numérique, ce signal numérique étant constitué par une suite d'échantillons, objet de la présente invention, comprend une pluralité SB de voies en parallèle recevant chacune ces échantillons E(n). Il est remarquable en ce que, pour une succession de blocs formés de SB échantillons, il comprend en cascade un étage de préfiltrage du signal numérique d'entrée, ce préfiltrage

EP 0 595 710 A1

correspondant à un filtrage polyphase modifié appliqué à chaque bloc d'échantillons pour délivrer des composantes de signaux préfiltrés et un étage de traitement par transformée fréquentielle inverse de dimension SB des composantes de signaux préfiltrés permettant de délivrer les signaux en sous-bandes Xk.

Le dispositif de reconstruction d'un signal numérique en sous-bandes, ce signal correspondant à une pluralité SB de signaux en sous-bandes Xk, k∈[0,SB-1] délivrés en parallèle sur une pluralité SB de voies en parallèle, à la suite d'une segmentation en sous-bandes d'un signal numérique suite d'échantillons E(n), est remarquable en ce qu'il comprend en cascade un étage de traitement des signaux en sous-bandes par transformée fréquentielle directe et un étage de post-filtrage, ce post-filtrage correspondant à un filtrage polyphase modifié, ce qui permet de délivrer le signal numérique reconstruit.

Le procédé et le dispositif de segmentation en sous-bandes respectivement de recontruction d'un signal numérique, objets de l'invention, trouvent application au traitement de signaux numériques audio- ou vidéonumériques par exemple, en particulier au traitement d'image bidimensionnel, séparable ou non séparable, et à la réalisation de modules de traitement correspondants sous forme de circuits intégrés.

L'objet de l'invention et en particulier le caractère d'équivalence, au point de vue traitement fonctionnel tout au moins, entre la réalisation, en combinaison, d'un pré-filtrage et d'un traitement par transformée fréquentielle du signal numérique ou d'un traitement par transformée fréquentielle et d'un post-filtrage et la réalisation d'un filtrage numérique en sous-bandes et d'un sous-échantillonnage dans le cas de la segmentation, d'une part, et, d'autre part, la réalisation en combinaison d'un traitement par tranformée fréquentielle et d'un post-filtrage ou d'un préfiltrage et d'un traitement par transformée fréquentielle, et la réalisation d'un suréchantillonnage et d'un filtrage numérique en sous-bandes dans le cas de la reconstruction, seront mieux compris à la lecture de la description et à l'observation des dessins ci-après dans lesquels, outre les figures 1a) à 1d) relatives à l'art antérieur :

- la figure 2a représente, sous forme de schéma synoptique purement illustratif, les étapes de mise en oeuvre du procédé objet de l'invention relativement à la segmentation et à la reconstruction du signal numérique,
- la figure 2b et la figure 2c représentent un premier respectivement un deuxième mode de mise en oeuvre du procédé objet de l'invention dans le cas de la segmentation respectivement celui de la reconstruction,
- la figure 3a représente une variante avantageuse de mise en oeuvre du procédé objet de l'invention d'une manière successive à au moins un signal en sous-bande, dans le cas de la segmentation, pour l'obtention de sous-bandes élémentaires,
- la figure 3b représente, de manière analogue, mais duale, à celle de la figure 3a, une variante avantageuse de mise en oeuvre du procédé objet de l'invention d'une manière successive à au moins un ensemble de sous-bandes élémentaires pour reconstituer un signal en sous-bande correspondant, dans le cas de la reconstruction du signal numérique,
- les figures 4 et 5 représentent, de manière synoptique, un mode de réalisation particulier d'un dispositif selon l'invention, dispositif de segmentation, respectivement de reconstruction,
- la figure 6a représente, de manière schématique, un mode de réalisation des fonctions de transfert des bancs de filtres modulés du dispositif de segmentation respectivement de reconstruction représenté en figure 1d),
- la figure 6b représente, de manière schématique, dans un cas particulier, un mode de réalisation de modules de filtrage permettant de réaliser soit la fonction de pré-filtrage, soit la fonction de post-filtrage de type polyphase modifié, dans le cas où le nombre de coefficients du banc de filtre utilisé est pair ou impair, et de taille inférieure ou égale à 2.SB,
- la figure 6c représente un module complet de traitement susceptible d'être utilisé tant pour la mise en oeuvre du dispositif de segmentation que de reconstruction, ce module de traitement consistant en la combinaison, en cascade, d'un module de filtrage représenté en figure 6b et d'un module rotation présent dans différentes réalisations de transformée fréquentielle, de type TCD inverse ou directe,
- les figures 6d et 6e représentent des modules uniques simplifiés réalisant la même fonction générale que le module complet de traitement représenté en figure 6c, mais permettant une économie importante d'opérations de traitement,
- la figure 7a est un diagramme explicatif du mode opératoire du module complet de traitement, plus particulièrement du module de filtrage permettant de réaliser la fonction de filtrage, pré- ou postfiltrage polyphase modifié,
- la figure 7b est un schéma synoptique général d'un mode de réalisation d'un dispositif de segmentation, conforme à l'objet de la présente invention, dans lequel un préfiltrage suivi d'une transformée fréquentielle inverse est effectué à partir d'un signal numérique d'entrée comportant des blocs d'échantillons numériques,
- la figure 7c est un diagramme de la fonction de transfert du dispositif tel que représenté en figure 7b,

4

- la figure 7d est un diagramme de la fonction de transfert du même dispositif tel que représenté en figure 7b dans le cas particulier préférentiel où des modules uniques simplifiés, tels que représentés en figure 6d et 6e, sont utilisés,
- la figure 7e donne une représentation, dans le cadre d'un traitement séparable de données d'image de télévision au format 4:2:2, de la découpe d'une telle image en bandes d'un nombre donné de lignes,
- la figure 7f donne une représentation du format des échantillons numériques d'entrée dans le cas de la figure 7e,
- la figure 7g est relative à un schéma de principe de mémorisation des calculs intermédiaires pour le traitement séparable mentionné relativement à la figure 7e,
- la figure 8a représente un schéma synoptique général d'un mode de réalisation d'un dispositif de reconstruction d'un signal numérique en sous-bandes, conforme à l'objet de la présente invention, dans lequel une transformée fréquentielle directe est effectuée, à partir des composantes de sous-bandes, pour un nombre de sous-bandes égal à huit,
- la figure 8b représente un diagramme de la fonction de transfert du dispositif tel que représenté en figure 8a,
- la figure 8c représente un diagramme de la fonction de transfert du même dispositif tel que représenté en figure 8a, dans le cas particulier préférentiel où des modules uniques et modules uniques simplifiés tels que représentés en figures 6d et 6e sont utilisés,
- la figure 8d représente de manière synoptique un mode de réalisation d'un dispositif selon l'invention, dispositif de segmentation, respectivement de reconstruction, réalisé à partir de filtres PRMF ou CPRMF,
- les figures 9a, 9b, 9c représentent différents modules types spécialement adaptés pour la réalisation sous forme de circuit intégré du dispositif de segmentation respectivement de reconstruction tels que représentés en figures 7b, 7d, respectivement 8a, 8c,
- les figures 10a, 10b, 10c représentent différents schémas d'implantation des modules types représentés en figures 9a à 9d pour réaliser le dispositif de segmentation et/ou de reconstruction d'un signal numérique en sous-bandes conforme à l'objet de l'invention.

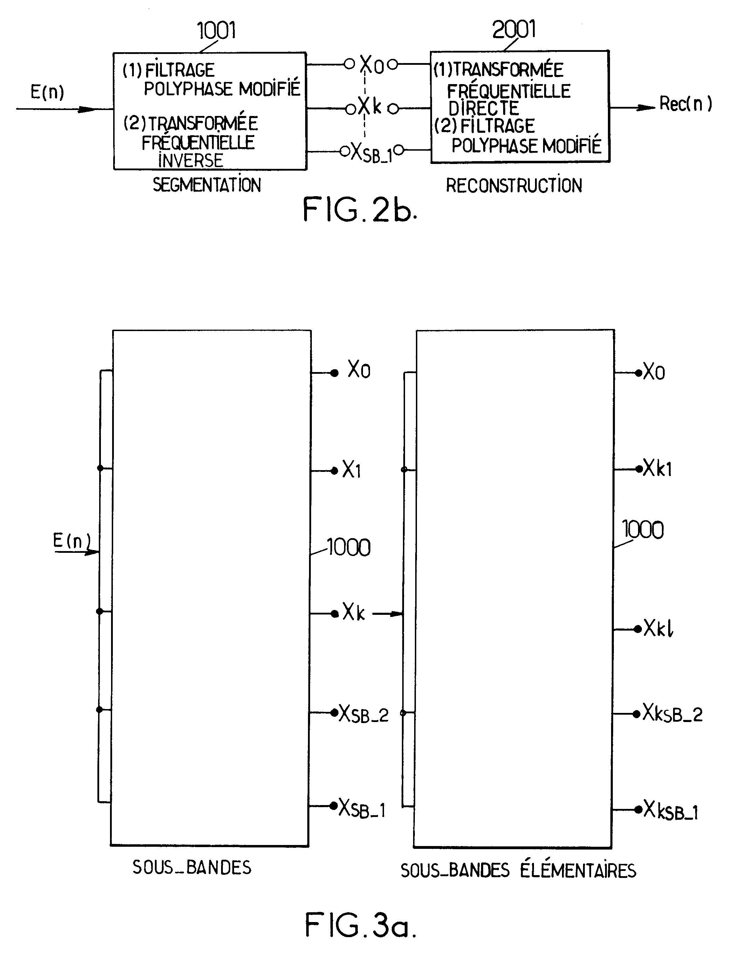

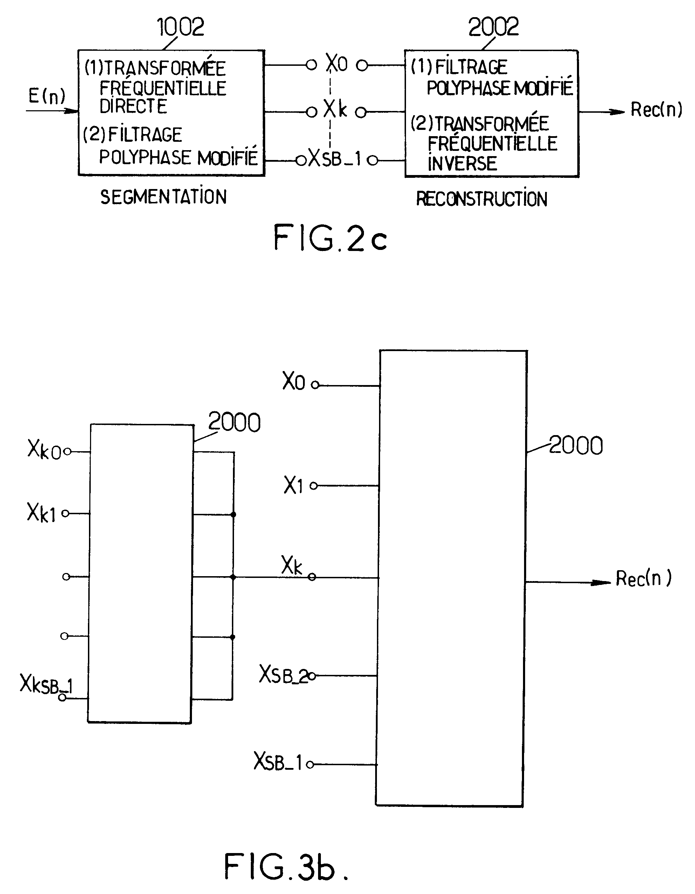

Le procédé de segmentation en sous-bandes respectivement de reconstruction d'un signal numérique, objet de la présente invention, sera maintenant décrit en liaison avec les figures 2a, 2b et 2c.

Selon la figure 2a précitée, le signal numérique soumis au traitement de segmentation en sous-bandes est constitué par une suite d'échantillons numériques notés $E(n)$ où n désigne l'ordre d'un échantillon courant considéré.

Ainsi qu'on le constatera à l'observation de la figure 2a, le procédé consiste à soumettre chaque échantillon à un traitement relatif tant au processus de segmentation en sous-bandes proprement dit qu'au processus de reconstruction à partir des sous-bandes correspondantes, ainsi qu'il sera décrit de manière plus détaillée ci-après dans la description.

Conformément au procédé objet de l'invention, le traitement permettant de réaliser le processus de segmentation consiste, selon un aspect remarquable du procédé objet de la présente invention, pour une succession de blocs d'échantillons formés par SB échantillons et constituant le signal numérique d'entrée, à effectuer, au moyen d'un filtrage prototype de type passe-bas à deux composantes, une composante symétrique et une composante antisymétrique, chacune modulée par une fonction périodique, ainsi que représenté en figure 2a, en combinaison, un filtrage et un traitement par transformée fréquentielle du signal numérique d'entrée. Le filtrage correspond à un filtrage polyphase modifié, ce qui permet de délivrer un signal en sous-bandes $X_k$ pour chaque voie de rang k correspondant.

La fonction périodique modulant la composante symétrique et la composante antisymétrique dépend du rang de chaque sous-bande, du nombre de sous-bandes et du nombre de coefficients du banc de filtres utilisé.

Sur la figure 2a, on a représenté le traitement correspondant 1000 effectué pour les composantes de rang k précitées, ce traitement consistant à effectuer en combinaison soit un filtrage polyphase modifié et une transformée fréquentielle, soit au contraire une transformée fréquentielle et un filtrage polyphase modifié dans des conditions qui seront explicitées ci-après. La combinaison correspondante du filtrage polyphase modifié et de la transformée fréquentielle, où réciproquement, au niveau de l'étape 1000 du processus de segmentation conforme à l'objet de la présente invention, est représentée par la réalisation successive des étapes (1) puis (2) correspondant respectivement soit à l'étape de filtrage polyphase modifié, suivie de la transformée fréquentielle, soit à l'étape de transformée fréquentielle suivie de l'étape de filtrage polyphase modifié.

Ainsi qu'on l'a donc représenté en figure 2b, l'étape 1000, pour les composantes en sous-bandes de rang k correspondantes, peut consister ainsi à réaliser un préfiltrage du signal numérique d'entrée, ce préfiltrage correspondant au filtrage polyphase modifié appliqué à chaque bloc d'échantillons pour obtenir un signal préfiltré correspondant, à l'étape (1) de l'étape 1001 de la figure 2b, cette étape (1) étant suivie de l'étape (2) de transformée fréquentielle inverse du signal préfiltré, de façon à délivrer le signal en sous-bande $X_k$ correspon-

dant.

De même, mais de manière duale, le procédé objet de la présente invention peut consister, ainsi que représenté en figure 2c, à effectuer, un traitement par transformée fréquentielle directe à l'étape (1) du processus de segmentation 1002 représenté en figure 2c, pour obtenir un signal transformé, cette étape (1) de traitement par transformée fréquentielle directe étant suivie d'un post-filtrage (2) du signal transformé, ce post-filtrage correspondant à un filtrage polyphase modifié pour délivrer le signal en sous-bande $X_k$ pour chaque voie de rang k correspondant.

En outre, ainsi qu'on l'a représenté en figure 2a, le procédé objet de la présente invention concerne un procédé de reconstruction d'un signal numérique en sous-bandes, ce signal correspondant à une pluralité de signaux en sous-bandes $X_k$. On notera que ces signaux en sous-bandes sont délivrés en parallèle suite à une segmentation en sous-bandes d'un signal numérique d'entrée E(n), la segmentation précitée ayant été effectuée par exemple conformément au procédé de segmentation précédemment décrit avec les figures 2a à 2c.

Le procédé de reconstruction objet de la présente invention consiste selon un aspect particulièrement avantageux, pour une pluralité de signaux en sous-bande $X_k$, à effectuer, au moyen d'un filtrage prototype de type passe-bas à deux composantes, une composante symétrique et une composante antisymétrique, chacune modulée par une fonction périodique, en combinaison, un filtrage et un traitement par transformée fréquentielle des signaux en sous-bande précités. Ce traitement de filtrage correspond à un traitement de filtrage de type polyphase modifié, ce qui permet de délivrer le signal numérique reconstruit Rec(n).

La fonction périodique modulant la composante symétrique et la composante antisymétrique dépend du rang de chaque sous-bande, du nombre de sous-bandes et du nombre de coefficients du banc de filtres utilisé.

De manière semblable au procédé de segmentation objet de la présente invention, le procédé de reconstruction est représenté en figure 2a par une étape 2000, pour les voies de rang k, étape 2000 dans laquelle peut être effectué, soit une transformée fréquentielle et un filtrage polyphase modifié, soit un filtrage polyphase modifié et une transformée fréquentielle, ainsi qu'il sera décrit dans la description de manière plus détaillée.

Ainsi qu'on l'a représenté en figure 2b, le procédé de reconstruction objet de la présente invention consiste par exemple à effectuer en une étape 2001, pour les voies de rang k, un traitement par transformée fréquentielle directe pour délivrer à partir de chaque signal numérique en sous-bande une pluralité de signaux numériques transformés et un traitement de post-filtrage de type polyphase modifié des signaux numériques transformés pour délivrer des signaux numériques transformés post-filtrés, ce qui permet de délivrer le signal numérique reconstruit Rec(n). Les étapes de transformée fréquentielle directe, respectivement de filtrage polyphase modifié, sont notées (1), respectivement (2), dans l'étape 2001 précédemment mentionnée.

De même, et de manière analogue au processus de segmentation précédemment décrit, en liaison avec la figure 2c, le procédé de reconstruction objet de la présente invention peut consister à effectuer pour les voies de rang k un traitement (1) de préfiltrage de type polyphase modifié des signaux numériques en sous-bandes, $X_k$, pour délivrer une pluralité de signaux numériques en sous-bandes préfiltrés, et un traitement par transformée fréquentielle inverse des signaux numériques en sous-bandes préfiltrés, cette opération de transformée fréquentielle étant notée (2) sur la figure 2c, l'ensemble du processus de reconstruction pour les voies de rang k étant notée 2002 sur la figure 2c, ce qui permet de délivrer le signal numérique reconstruit Rec(n).

On notera que le procédé de segmentation en sous-bande, respectivement de reconstruction d'un signal numérique, objet de la présente invention, peut être appliqué sur tout type de signal numérique d'entrée, signal audio- ou vidéo-numérique, en particulier sur des signaux vidéo-bidimensionnels, lesquels peuvent être soumis à un traitement de type séparable par exemple, pour obtenir un nombre déterminé SBx. SBy de sous-bandes. Toutefois, le procédé objet de la présente invention peut être appliqué au cas général des signaux vidéo-bidimensionnels, séparables ou non.

On notera en outre que le procédé objet de la présente invention n'est pas limité à un signal numérique de type paticulier. En particulier le processus de segmentation respectivement de reconstruction peut être réappliqué en cascade sur une ou plusieurs des sorties respectivement entrées de chaque voie de segmentation respectivement de reconstruction ainsi qu'il sera décrit ci-après en liaison avec les figures 3a et 3b.

Ainsi qu'on l'a représenté sur la figure 3a, le procédé de segmentation, objet de la présente invention, peut ainsi consister à soumettre l'un au moins des signaux en sous-bandes $X_k$ délivrés au traitement précédemment décrit sur une pluralité de voies ou de sous-bandes élémentaires de façon à décomposer ce signal en sous-bande $X_k$ en signaux en sous-bandes élémentaires, notés $X_{k1}$. On comprend bien entendu que tout signal en sous-bande peut ainsi être décomposé en un nombre SBE de sous-bandes élémentaires. Le traitement précité peut alors être réappliqué sur au moins une des sous-bandes élémentaires pour engendrer des sous bandes élémentaires de rang successif supérieur correspondant. Cette itération du procédé et du traitement en parallèle correspondant à celui-ci, conformément à l'objet de la présente invention, permet ainsi d'effectuer une décomposition sophistiquée du signal numérique d'origine, en sous-bandes et/ou en sous-bandes élémentaires, de façon à concentrer l'énergie du signal initial dans certaines sous-bandes ou sous-bandes élémentaires

6

de rang successif supérieur, ce qui permet, le cas échéant, d'envisager des traitements spécifiques à chaque sous-bande, en fonction par exemple des conditions de transmission. Sur la figure 3a, l'étape 1000 délivrant les signaux en sous-bande est alors réappliquée sur un signal en sous-bande $X_k$ par exemple pour délivrer les signaux en sous-bandes élémentaires $X_{k1}$, ainsi que représenté sur la figure précitée. D'une manière générale, on comprendra que le nombre de sous-bandes élémentaires peut par exemple être pris égal au nombre de sous-bandes avec SBE = SB.

De la même façon, le procédé de reconstruction d'un signal numérique, conforme à l'objet de la présente invention, peut être appliqué sur des signaux numériques en sous-bandes élémentaires, ainsi que représenté en figure 3b, les signaux en sous-bandes élémentaires, $X_{k0}$ à $X_{ksB-1}$, étant soumis à un processus de reconstruction au moyen d'un processus de traitement noté 2000, tel que représenté en figure 2a, le signal en sous-bandes élémentaires de rang p, p = 1 dans le cas de la figure 3b, étant soumis au procédé de reconstruction conforme à l'objet de la présente invention pour engendrer, par reconstruction, un signal en sous-bande élémentaire de rang inférieur successivement puis le signal en sous-bande $X_k$ correspondant.

On comprend bien sûr que le processus de reconstruction, tel que représenté en figure 3b, peut avantageusement être mis en oeuvre lorsqu'un signal numérique d'entrée a été décomposé en sous-bandes, respectivement en sous-bandes élémentaires, conformément au procédé objet de l'invention tel que représenté en figure 3a.

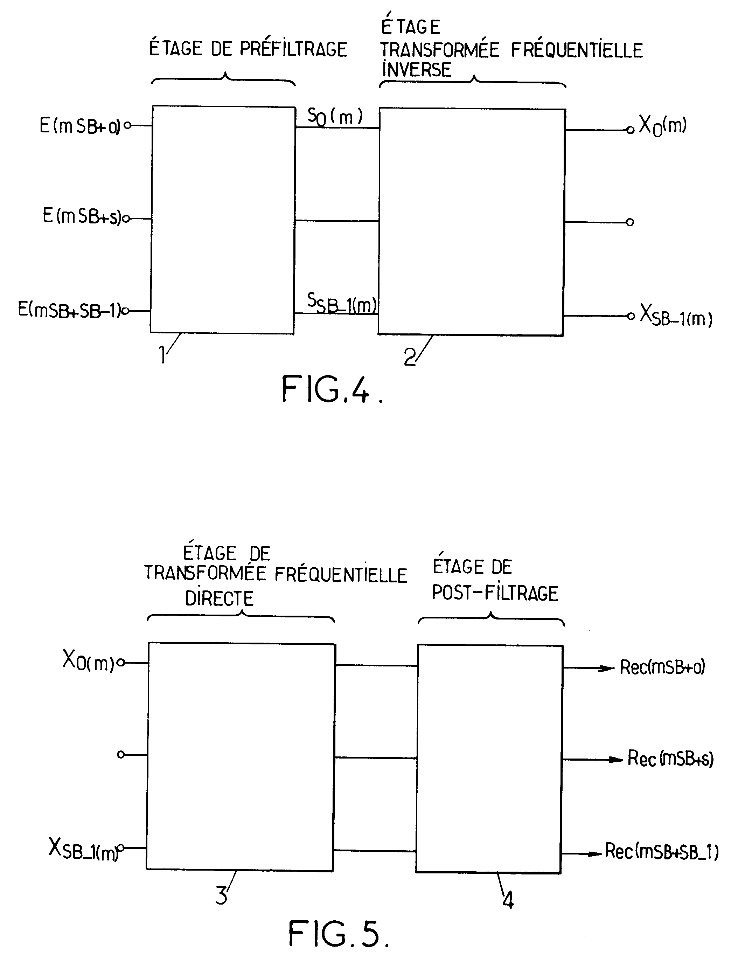

Une description plus détaillée du dispositif de segmentation en sous-bandes respectivement de reconstruction d'un signal numérique conforme à l'objet de la présente invention sera maintenant donnée en liaison avec les figures 4, 5 et suivantes.

Selon la figure 4, le dispositif de segmentation objet de l'invention comprend un étage de préfiltrage 1 des signaux numériques d'entrée, notés E(m.SB+s), $s \in [0,SB-1]$ et m désignant le numéro du bloc courant de taille SB. L'étage de préfiltrage 1 est suivi d'un étage 2 de transformée fréquentielle inverse. On note que l'étage de préfiltrage délivre des composantes de signaux préfiltrés $S_0(m)$ à $S_{SB-1}(m)$ à l'étage 2 de transformée fréquentielle, lequel délivre les composantes de signal en sous-bandes $X_0(m)$ à $X_{SB-1}(m)$.

De manière duale, le dispositif de segmentation objet de la présente invention peut, ainsi que décrit précédemment relativement au procédé selon l'invention, comporter un étage de transformée fréquentielle directe recevant les échantillons E(mSB+s) et délivrant des signaux de transformée fréquentielle à un étage de post-filtrage, lequel délivre les composantes de signal en sous-bandes $X_0(m)$ à $X_{SB-1}(m)$. Dans les deux cas, l'étage de pré- respectivement post-filtrage permet de réaliser un filtrage polyphase modifié.

De la même manière, ainsi que représenté en figure 5, le dispositif de reconstruction des composantes de signal numérique en sous-bandes $X_0(m)$ à $X_{SB-1}(m)$ comprend un étage 3 de transformée fréquentielle directe délivrant des signaux de transformée fréquentielle et un étage de post-filtrage 4 délivrant à partir de ces derniers le signal reconstruit Rec(m.SB+s). De manière duale, le dispositif de reconstruction objet de la présente invention peut également comporter un étage de pré-filtrage suivi d'un étage de transformée fréquentielle inverse ainsi que décrit précédemment dans la description relativement au procédé, l'étage de post- respectivement de pré-filtrage permettant de réaliser un filtrage polyphase modifié.

On notera, en ce qui concerne le dispositif de segmentation, respectivement de reconstruction d'un signal numérique en sous-bandes objet de la présente invention, que celui-ci permet, après segmentation en sous-bande, une reconstruction parfaite du signal numérique d'entrée, ou signal numérique source, les filtres utilisés pouvant avantageusement être des filtres ou bancs de filtres modulés de type PRMF, tant pour la phase de segmentation que l'on appellera, par commodité par exemple, processus de traitement direct que pour la phase de reconstruction que l'on appellera processus de traitement inverse.

On notera en particulier que le dispositif objet de la présente invention permet une approche séparable du traitement de signaux d'images vidéo pour décomposer un signal bidimensionnel en SBx.SBy sous-bandes. Toutefois, les techniques nouvelles développées dans ce cas particulier peuvent également être immédiatement étendues au cas général, séparable ou non. En outre, le type de traitement direct ou inverse précédemment mentionné peut être réappliqué en cascade sur une ou plusieurs sorties, c'est-à-dire une ou plusieurs sous-bandes, respectivement sur une ou plusieurs entrées, pour reconstituer le signal d'origine, ainsi que précédemment décrit en liaison avec les figures 3a et 3b.

On notera en particulier, selon un aspect particulièrement avantageux du dispositif objet de la présente invention, que le banc de filtre utilisé peut être un banc de filtre à reconstruction parfaite, ou presque parfaite, de type CPRMF, possédant un nombre impair, NF, de coefficients. Ce type de filtre permet alors une décomposition en SB sous-bandes, à partir du banc de filtres modulé associé, ainsi qu'il sera décrit ultérieurement dans la description.

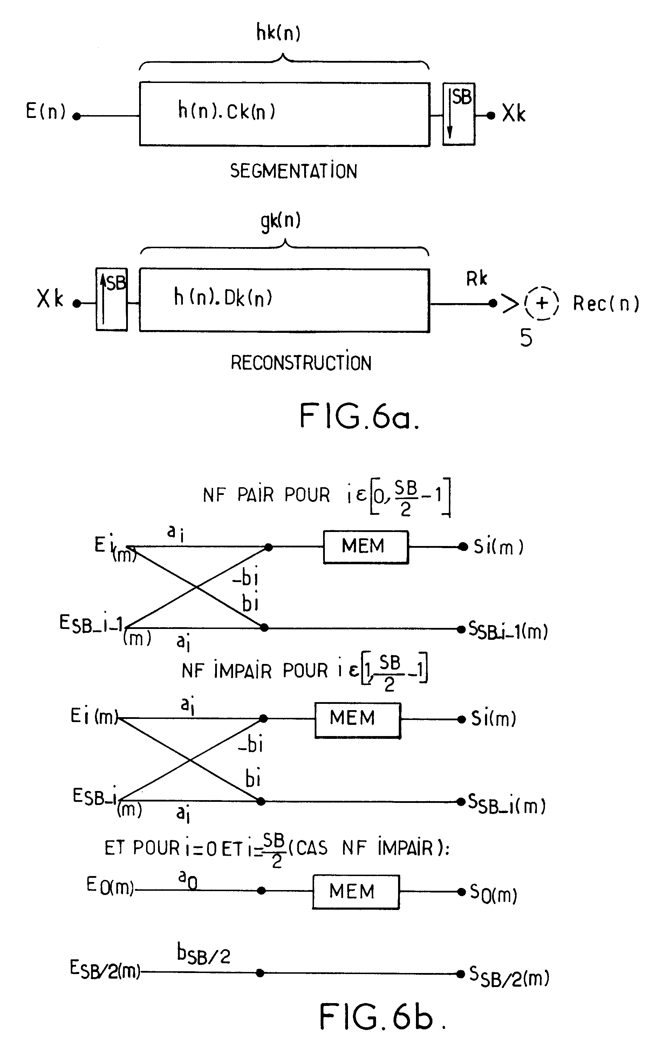

Une description plus détaillée de la réalisation de bancs de filtre modulés d'analyse, c'est-à-dire de segmentation, et de synthèse, c'est-à-dire de reconstruction, à partir d'un même filtre prototype h(n) pour la mise en oeuvre du procédé et du dispositif objets de la présente invention, sera maintenant donnée en liaison avec les figures 6a à 6e.

D'une manière générale, on indique que les bancs de filtres utilisés peuvent consister en des filtres MOT, ou "Modulated Orthogonal Transforms" en langage anglo-saxon pour Transformées Régulières Orthogonales Modulées M Sous-Bandes, ou en des bancs de filtres PRMF. La famille des filtres MOT recouvre non seulement l'ensemble des bancs de filtres PRMF, le nombre NF de coefficients et le nombre SB de sous-bandes pouvant être choisis quelconques, mais aussi toutes les transformées othogonales ou CQF (Conjugate Quadrature Filters) à décomposition en deux sous-bandes.

L'expression générique de la fonction de transfert h(n) du filtre prototype est alors de la forme :

$$h(n) = 1/2 [hs(n) + ha(n)],$$

où hs(n) et ha(n) représentent respectivement les composantes symétrique et antisymétrique de h(n), avec

$$hs(n) = h(n) + h(NF - 1 - n)$$
$$ha(n) = h(n) - h(NF - 1 - n).$$

Les filtres d'analyse ou segmentation, respectivement de synthèse ou reconstruction, sont alors obtenus après sommation des termes résultant de modulations différentes appliquées séparément à chacune des composantes symétrique et antisymétrique du filtre prototype, et leurs fonctions de transfert sont exprimées selon les relations générales ci-après :

$$hk(n) = 1/2 [hs(n).Ck(n) - ha(n).Ck(NF - 1 - n)]$$

pour les filtres d'analyse, et respectivement

$$gk(n) = 1/2 [hs(n).Ck(NF - 1 - n) + ha(n).Ck(n)] = hk(NF - 1 - n)$$

pour les filtres de synthèse.

Dans les relations précédentes, on indique que k désigne le rang de la sous-bande considérée, et les formules des fonctions de modulation sont par définition :

$$Ck(n) = 2.Cos \left[ \frac{\pi.(2k+1).(2n-NF+1-SB)}{4\ SB} \right]$$

$$Ck(NF-1-n) = 2.Cos \left[ \frac{\pi.(2k+1).(2n-NF+1+SB)}{4\ SB} \right]$$

NF désignant le nombre de coefficients du banc de filtres utilisé et SB le nombre de sous-bandes, n désignant l'indice courant.

Un cas particulier intéressant de la famille des filtres MOT est celui pour lequel la composante antisymétrique est prise nulle, ha(n) = 0. Dans ce cas, les filtres satisfaisant à la condition précitée ne sont autres que les filtres PRMF précédemment cités dans la description.

Dans la théorie générale des bancs de filtres MOT, les composantes symétrique hs(n) et antisymétrique ha(n) du filtre prototype passe-bas doivent satisfaire aux conditions de reconstruction parfaite. Cependant, lors de la mise en oeuvre de filtres MOT, la suppression de plusieurs restrictions, par rapport au cas de la mise en oeuvre de filtres PRMF, permet d'obtenir une plus grande liberté de choix des paramètres des filtres que lors de la mise en oeuvre de filtres PRMF. En outre, la mise en oeuvre de filtres MOT de longueur courte avec un nombre de coefficients NF ≦ 2.SB, partaitement adaptés à la réduction de débit en codage d'image, autorise également une réalisation efficace en circuit intégré à base de traitement par algorithme rapide, au moyen d'une structure similaire à celle décrite ci-après dans le cadre de filtres PRMF.

Selon la figure 6a précitée, le filtrage numérique en sous-bandes formé par un filtre prototype de type passe-bas modulé par une fonction périodique, ce filtre numérique en sous-bandes pour la voie ou sous-bande de rang k correspondant étant noté $h_k(n)$ doit correspondre à celui d'un filtre prototype de type passe-bas, ainsi que mentionné précédemment dans la description, modulé par une fonction périodique. Il correspond, ainsi que représenté en figure 6a, à des bancs de filtre PRMF présentant une fonction de transfert de segmentation h(n).Ck(n), h(n) représentant la fonction de transfert du filtre prototype.

Il en est de même en ce qui concerne le filtre numérique en sous-bandes de reconstruction, noté $g_k(n)$, lequel correspond au même filtre prototype de fonction de transfert h(n) modulé par une fonction Dk(n).

Dans les dispositifs de segmentation d'un signal numérique en sous-bandes, respectivement de reconstruction, les fonctions périodiques de modulation sont formées par des modules présentant une fonction de transfert :

$$Ck(n) = 2.Cos\left(\frac{\pi.(2k+1).(2n-NF+1-SB)}{4.SB}\right)$$

pour le dispositif de segmentation.

De la même manière, la fonction périodique de modulation pour le dispositif de reconstruction vérifie la relation :

$$Dk(n) = 2.Cos\left(\frac{\pi.(2k+1).(2n-NF+1+SB)}{4.SB}\right)$$

Les fonctions de transfert précédemment mentionnées sont données à titre d'exemple, un résultat identique ou quasi-identique en pratique pouvant être obtenu en remplaçant Ck(n) par -Ck(n) ou en prévoyant une normalisation différente, la normalisation correspondant au coefficient 2 affectant chaque fonction de transfert, ce coefficient pouvant être pris égal à une autre valeur.

On notera que les fonctions de transfert précitées présentent une loi de périodicité que l'on peut traduire par les égalités suivantes :

$$Ck(n + 2.r.SB) = (-1)^r.Ck(n)$$
$$Dk(NF - 1 - n) = Ck(n).$$

Les propriétés de périodicité dans les processus de traitement précités de filtrage suivi de sous-échantillonnage, respectivement de sur-échantillonnage suivi de filtrage dans les processus de segmentation, respectivement de reconstruction, permettent de mettre en évidence l'équivalence, au moins au plan traitement fonctionnel, de ces traitements avec des traitements par transformée fréquentielle inverse, respectivement directe, ainsi qu'il sera décrit ci-après dans la description.

Conformément à l'aspect particulièrement avantageux précité, pour une succession de blocs d'échantillons formés de SB échantillons, le dispositif de segmentation, objet de la présente invention, peut comprendre en cascade, ainsi que déjà mentionné en liaison avec la figure 4, un étage 1 de préfiltrage du signal numérique d'entrée E(mSB+s), ce préfiltrage correspondant à un filtrage polyphase modifié appliqué à chaque bloc d'échantillons pour délivrer des composantes de signaux préfiltrés.

Cet étage 1 de préfiltrage est suivi d'un étage 2 de traitement par transformée fréquentielle inverse de dimension SB des composantes de signaux préfiltrés permettant de délivrer les signaux en sous-bandes $X_k$.

De la même manière, le dispositif de reconstruction, objet de l'invention, tel que représenté en figure 5, comprend pour une pluralité de SB signaux en sous-bandes pour les voies considérées, un étage 3 de traitement des signaux en sous-bandes par transformée fréquentielle directe suivi d'un étage 4 de post-filtrage permettant de délivrer les composantes de sous-bandes du signal numérique reconstruit.

En effet, les signaux numériques en sous-bandes peuvent s'écrire :

$$Xk(m) = \sum_{n=0}^{NF-1} h(n).Ck(n).E(m.SB-n)$$

De même, les points reconstruits, c'est-à-dire le signal reconstruit après segmentation, vérifient la relation :

$$Rec(n) = \sum_{k=0}^{SB-1}\sum_{m\in Z} h(n-m.SB).Dk(n-m.SB).Xk(m)$$

On rappelle que dans les relations précédemment citées, k désigne le rang de chaque sous-bande, m représentant la position d'un échantillon dans la sous-bande de rang k correspondant, Z désignant l'ensemble des entiers relatifs, seul un nombre fini de points étant utilisé.

Pour des positions particulières dans le filtre $N_0$, $N_1$ et $N_2$ telles que par exemple :

$$N_0 = (NF - 1)/2, \quad N_1 = N_0 + SB/2 \quad et \quad N_2 = N_0 - SB/2,$$

ces valeurs particulières n'étant pas limitatives, et de paramètres de choix du filtre prototype $\theta=0$ pour NF impair, et $\theta=0,5$ pour NF pair, les symétries des fonctions de transfert précitées permettent d'écrire les relations :

$$Ck(N1 + s + \theta) = Ck(N1 - s - \theta)$$
$$Ck(N2 + s + \theta) = -Ck(N2 - s - \theta)$$

Dans les relations précitées, on indique que s représente un indice de position du coefficient du filtre correspondant, avec $s \in [0,SB-1]$.

Pour des produits de filtrage du filtrage appliqué à chaque échantillon vérifiant la relation :

$$P_{N1+s+\theta}(m) = \sum_{r \in Z} (-1)^r . h(N1+s+\theta+2.r.SB) . E(m.SB-N1-s-\theta-2.r.SB)$$

les filtrages polyphase modifiés vérifient les relations :

$$S_{s+\theta}(m) = 2.(P_{N1+s+\theta}(m) + P_{N1-s-\theta}(m)) \qquad si\ s+\theta \neq 0$$

et

$$S_0(m) = 2.\sqrt{2}.P_{N1}(m)\ si\ s+\theta = 0, \qquad avec\ s \in [0,SB-1].$$

Les composantes en sous-bandes vérifient alors la relation :

$$X_k(m) = \sum_{s=0}^{SB-1} \delta(s+\theta).S_{s+\theta}(m).cos\left(\frac{\pi.(2k+1).(s+\theta)}{2.SB}\right)$$

Dans la relation précitée, on note que :

$$\delta(s+\theta) = 1/\sqrt{2}, \qquad si\ s+\theta = 0,$$
$$et\ \delta(s+\theta) = 1, \qquad sinon.$$

On notera que l'expression donnée dans la relation précédente des composantes en sous-bandes de rang k est identique à celle obtenue par application d'une transformée fréquentielle inverse, de type DCT inverse, de taille SB appliquée aux coefficients $S_{s+\theta}(m)$ constitutifs des circuits de préfiltrage du signal numérique d'entrée, ce préfiltrage correspondant ainsi à un filtrage polyphase modifié.

Dans le cas du processus de traitement inverse, c'est-à-dire du processus de reconstruction, pour un indice n désignant le rang de l'échantillon reconstruit, avec n = N2+s+θ+r.SB, avec $s \in [0,SB-1]$ et $r \in Z$, les propriétés de symétrie et de périodicité déjà énoncées des fonctions de transfert Ck(n) et Dk(n) permettent d'établir un signal reconstruit vérifiant la relation :

$$Rec(N2+s+\theta+r.SB) = \frac{SB}{\delta(s+\theta)} . \sum_{m \in Z} h(N2+s+\theta+(r-m).SB) . A_{s+\theta+(r-m).SB}(m)$$

Dans cette relation, l'expression $A_{s+\theta}(m)$ vérifie la relation :

$$A_{s+\theta}(m) = \frac{2.\delta(s+\theta)}{SB} . \sum_{k=0}^{SB-1} cos\left(\frac{\pi.(2k+1).(s+\theta)}{2.SB}\right) . X_k(m)$$

et pour d'autres valeurs vérifie les relations, avec $u \in Z$ :

$$A_{s+\theta+2uSB}(m) = (-1)^u A_{s+\theta}(m)$$
$$A_{s+\theta+(2u+1)SB}(m) = (-1)^{u+1} A_{SB-s-\theta}(m)$$
$$A_{SB}(m) = 0\ si\ NF\ impair.$$

Dans l'expression du signal reconstruit donné par la relation précédente, on reconnaît un processus de post-filtrage opéré sur les coefficients issus d'une transformée fréquentielle directe de type DCT.

On note en particulier que la nature du filtre prototype n'intervient pas pour la mise en évidence des transformations fréquentielles de type DCT inverse et directe dans les opérations de segmentation et de reconstruction.

Par contre, la nature du filtre prototype utilisé est liée aux conditions de reconstruction parfaite du signal d'entrée après décomposition-reconstruction.

En particulier, dans le cas du codage d'images, il est intéressant de concentrer l'énergie sur un nombre réduit de sous-bandes, ceci afin de transmettre un minimum d'information utile dans le domaine des sous-bandes. Le respect du critère précédemment mentionné ajouté aux contraintes de reconstruction parfaite permet de définir des filtres prototypes de fonction de transfert h(n) pour un banc de filtre PRMF. On indique qu'en raison d'une quantification des valeurs utilisées sur un nombre fini de bits, les filtres utilisés seront désignés par filtres CPRMF, ainsi que désigné précédemment.

Ainsi, pour un nombre de coefficients NF≦2.SB, seules deux solutions sont possibles et la fonction de transfert du filtre prototype utilisé vérifie la relation :

$$h(n) \ = \ \frac{1}{\sqrt{2.SB}} \cdot \sin\frac{(n+1).\pi}{2.SB}, \qquad \text{avec } n \in [0, 2.SB - 2].$$

cette relation étant vérifiée pour NF impair, égal à 2.SB-1, et pour un nombre pair NF de coefficients de filtre NF = 2.SB, la fonction de transfert du filtre prototype vérifie alors la relation :

$$h(n) \ = \ \frac{1}{\sqrt{2.SB}} \cdot \sin\frac{(n+0,5).\pi}{2.SB}, \qquad \text{avec } n \in [0, 2.SB - 1].$$

On notera cependant que la fonction de transfert h(n) du filtre prototype considéré peut être exprimée également selon les règles de correspondance entre cosinus et sinus, sans sortir du cadre de l'objet de la présente invention.

Les modules de préfiltrage respectivement de post-filtrage correspondant à un filtrage de type polyphase modifié, placé en entrée du dispositif de segmentation respectivement en sortie de dispositif de reconstruction, peuvent permettre de tirer bénéfice des propriétés du filtre prototype h(n), dont ils se déduisent, pour se combiner aux modules de treillis de rotation obtenus en entrée de la transformation fréquentielle inverse de type DCT ou à ceux placés en sortie de la transformée fréquentielle directe de type DCT, ces transformées étant respectivement de type III ou IV (confer P.YIP et K.R.RAO, "Fast Decimation in Time Algorithms for a Family of Discrete Sine and Cosine Transforms", Circuits Systems Signal Process, Vol 3, N°4, 1984), selon le nombre NF de coefficients du banc de filtre utilisé. Les remarques précédentes, compte tenu de l'utilisation de diagrammes de calculs connus pour la DCT, tels celui de Chen, par exemple, permettent une simplification globale du processus de traitement des transformations directe et inverse basées sur l'utilisation de bancs de filtre PRMF, en particulier dans le cas qui sera décrit ci-après.

Une transformée de type DCT de type III peut s'exprimer en fonction des parties réelles et imaginaires d'une transformée de Fourier rapide FFT et une transformée fréquentielle de type DCT de type IV obtenue pour un nombre pair de coefficients du banc de filtre utilisé peut également s'exprimer en fonction des parties réelles et imaginaires d'une transformée de Fourier rapide FFT impaire, combinée à des modules de rotation.

La forme particulière des filtres prototype précédemment définis permet alors une réalisation des fonctions de préfiltrage respectivement de postfiltrage polyphase modifié permettant de faire apparaître une fonction en treillis explicitée ci-après.

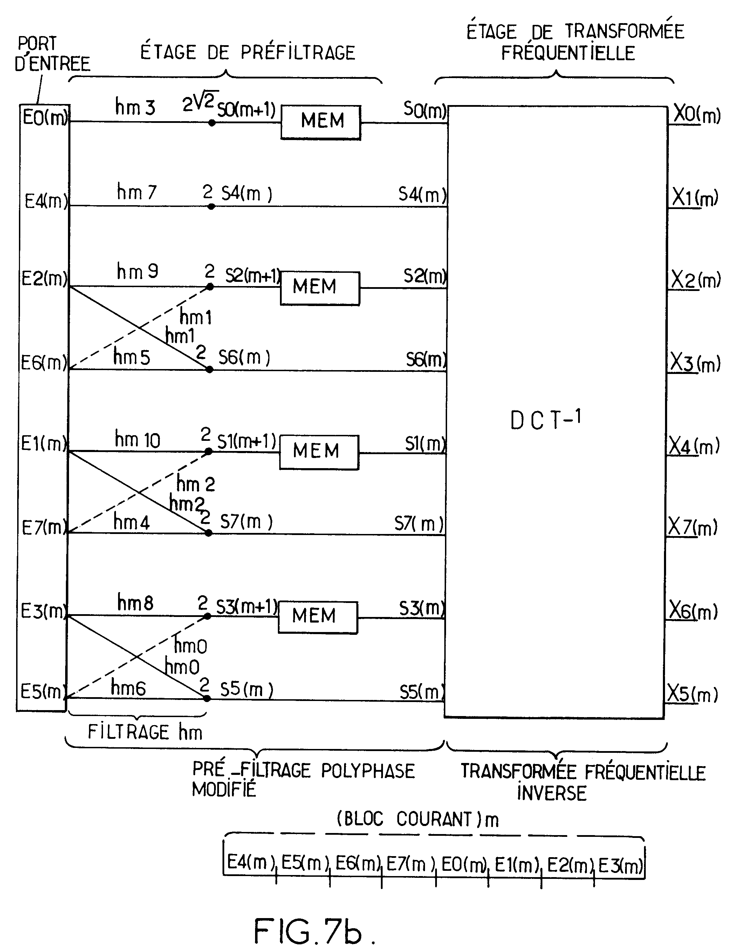

Dans la description qui suit, i désigne l'indice des échantillons classés dans l'ordre tel que représenté au bas de la figure 7b, tels que des échantillons d'images ou pixels pris dans un bloc d'échantillons de taille SB,

$$i \in [0, \frac{SB}{2}-1]$$

l'indice i étant facilement relié à l'indice n précédemment mentionné de chaque échantillon du signal d'entrée en relation avec l'adresse de chaque bloc.

Dans le cas précité, les étages de préfiltrage du signal numérique d'entrée respectivement de postfiltrage permettant de délivrer les composantes en sous-bande du signal numérique reconstruit peuvent alors, ainsi que représenté en figure 6b dans le cas de l'analyse, être formés par des modules en treillis dont la fonction de transfert vérifie la relation :

$$S_i(m) \ = \ a_i.E_i(m - 1) - b_i.E_{SB - i - 2\theta}(m - 1)$$
$$S_{SB - i - 2\theta}(m) \ = \ a_i.E_{SB - i - 2\theta}(m) + b_i.E_i(m)$$

pour NF pair, avec $i \in [0, \frac{SB}{2}-1]$.

Pour NF nombre d'éléments du filtre du banc de filtres utilisé impair, le module en treillis vérifie non seulement les relations précédemment mentionnées pour $i \in [1, \frac{SB}{2}-1]$, ce même module en treillis vérifiant en outre la relation :

$$S_o(m) \ = \ a_o.E_o(m - 1) \text{ pour } i \ = \ 0 \text{ et}$$
$$S_{SB/2}(m) \ = \ b_{SB/2}.E_{SB/2}(m) \text{ pour } i \ = \ \frac{SB}{2}$$

On notera bien sûr que dans ces relations, les coefficients $a_i$ et $b_i$ sont des valeurs numériques déterminées affectées au rang i de chaque échantillon, ces valeurs étant obtenues à partir des coefficients du filtre prototype. Dans les relations précédentes, m et m-1 désigne une fonction de mémorisation et de retard correspondant du bloc courant m au bloc antérieur m-1. Les fonctions en treillis représentées en figure 6b sont représentées pour θ=0,5 pour NF pair, respectivement θ=0 pour NF impair.

Le préfiltrage et le postfiltrage réalisés sous la forme de treillis précédemment indiquée, associés avec le premier étage ou avec le dernier étage également en treillis de certaines réalisations des transformées fréquentielles inverses respectivement directes de type DCT III ou IV précédemment mentionnées, permettent de faire apparaître différentes structures en parallèle particulièrement avantageuses et simplifiées offrant des gains en nombre d'opérations (multiplications) proches de 50 %.

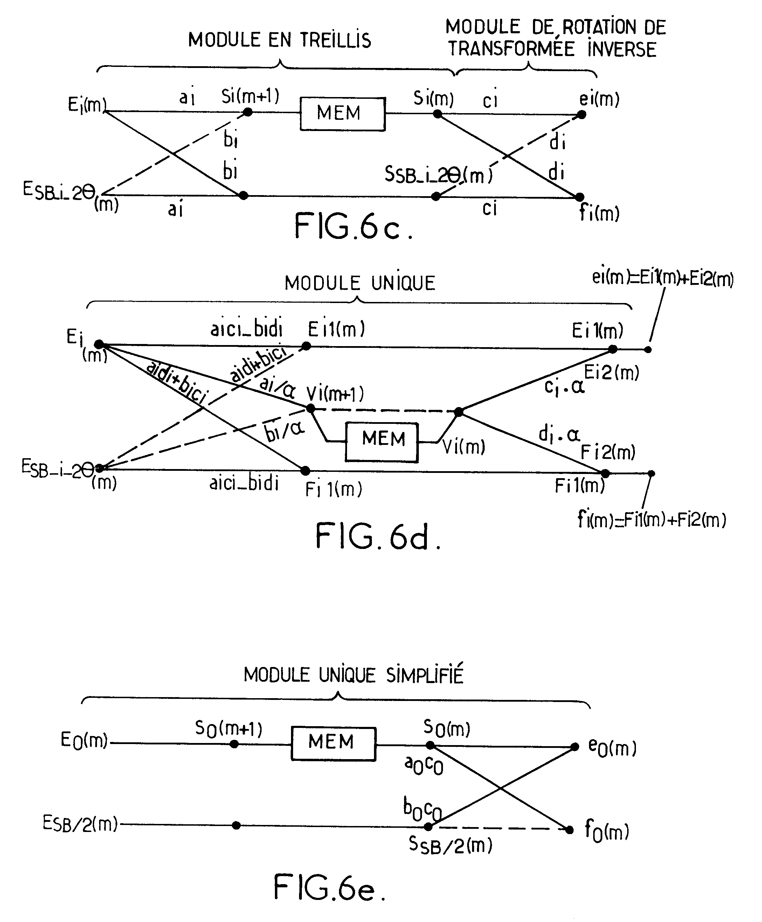

Ainsi que représenté en figure 6c, les circuits de traitement par transformée fréquentielle inverse respectivement directe peuvent être formés par des modules de rotation d'entrée de transformée en cosinus discrète inverse respectivement de rotation de sortie de transformée en cosinus discrète directe, ces modules rotation présentant une fonction de transfert à partir des signaux préfiltrés $S_i, S_{SB-i-2\theta}$ vérifiant la relation :

$$e_i(m) = C_i.S_i(m) - d_i.S_{SB-i-2\theta}(m)$$
$$f_i(m) = c_i.S_{SB-i-2\theta}(m) + d_i.S_i(m)$$

Ainsi, le module en treillis réalisant le préfiltrage polyphase modifié et le module rotation d'entrée de transformée en cosinus discrète sont montés en cascade, ainsi que représenté en figure 6c.

Les modules en cascade représentés en figure 6c peuvent alors être réduits, de manière avantageuse, à un module unique assurant l'ensemble du traitement, ainsi que représenté en figures 6d et 6e.

Le module unique tel que représenté en figure 6d comprend un sous-module en treillis direct dont la fonction de transfert vérifie la relation :

$$E_{i1}(m) = [ (a_ic_i - b_id_i)E_i(m) - (a_id_i + b_ic_i)E_{SB-i-2\theta}(m) ]$$
$$F_{i1}(m) = [ (a_id_i + b_ic_i)E_i(m) + (a_ic_i + b_id_i)E_{SB-i-2\theta}(m) ]$$

Dans la relation précitée, les coefficients ai et bi respectivement ci et di sont les coefficients correspondant à ceux de la figure 6c.

On notera bien sûr que dans les figures 6c, 6d et 6e, les lignes continues entre deux noeuds des modules en treillis correspondent à une sommation pondérée par le coefficient correspondant, $a_i$ ou $c_i$, $b_i$ ou $d_i$, alors que les traits en lignes discontinues entre deux noeuds correspondent à une soustraction pondérée par les coefficients précités correspondant.

En outre, au sous-module en treillis direct est associé un sous-module en parallèle et dont la fonction de transfert vérifie en outre la relation :

$$V_i(m + 1) = \frac{a_i}{\alpha}.E_i(m) - \frac{b_i}{\alpha}.E_{SB-i-2\theta}(m)$$
$$E_{i2}(m) = [ V_i(m) - V_i(m + 1) ] (\alpha.c_i)$$
$$F_{i2}(m) = [ V_i(m) - V_i(m + 1) ] (\alpha.d_i).$$

Le signal résultant s'écrit $e_i(m) = E_{i1}(m) + E_{i2}(m)$, $f_i(m) = F_{i1}(m) + F_{i2}(m)$.

Sur la figure 6d, on notera la présence du coefficient $\alpha$, ce coefficient prenant une valeur déterminée pour $i \in [0, \frac{SB}{2}-1]$ pour NF pair, et $i \in [1, \frac{SB}{2}-1]$ pour NF impair.

En ce qui concerne la valeur du paramètre $\alpha$, celui-ci peut être choisi de manière à optimiser dans les modules correspondants des paramètres tels que la dynamique des coefficients, la représentation des coefficients sur un nombre limité de bits, en réalisation dite en langage anglo-saxon "shifts and adds" ou d'autres critères à optimiser. On notera en particulier que la valeur de a peut être prise égale à $\alpha = 1/c_i$ ou $\alpha = 1/d_i$ ou $\alpha = a_i$ ou $\alpha = b_i$ pour supprimer en fait une opération de multiplication.

Pour un nombre NF impair de coefficients de filtre utilisés et i=0 et i=SB/2, la fonction de transfert du module unique correspondant vérifie la relation :

$$e_0(m) = a_0.c_0.E_0(m - 1) + b_0.c_0.E_{SB/2}(m)$$
$$f_0(m) = a_0.c_0.E_0(m - 1) - b_0.c_0.E_{SB/2}(m).$$

En particulier, pour des filtres prototype h(n) optimaux tels que décrits précédemment, les valeurs $a_i.c_i - b_i.d_i$ et $a_i.d_i + b_i.c_i$ deviennent égales avec un choix approprié de normalisation de h à +1/2 ou -1/2, ce qui peut être réalisé par un simple décalage binaire du coefficient correspondant. Un choix avantageux particulièrement intéressant peut consister à prendre :

$$a_i.c_i - b_i.d_i = a_i.d_i + b_i.c_i = 1/2.$$

On notera que l'exemple de détermination des fonctions de transfert des modules de préfiltrage de type polyphase modifié peut être appliqué sans difficulté, en raison de la symétrie établie précédemment dans la description, pour les modules de postfiltrage utilisés dans le processus de transformation inverse conduisant exactement au même nombre d'opérations que dans le processus de transformation direct.

On notera toutefois qu'il est possible d'intervertir les processus de transformation directe respectivement de transformation inverse ainsi que décrit en liaison avec le procédé de la présente invention.

En effet, la transformation directe ou de segmentation peut alors se décomposer en une transformée fréquentielle directe de type DCT suivie d'un postfiltrage et la transformation inverse ou de reconstruction en un processus de préfiltrage suivi d'un traitement de type transformée fréquentielle inverse de type DCT.

Le dispositif objet de la présente invention peut donc être considéré comme susceptible de délivrer soit des coefficients de transformée fréquentielle de type DCT soit des coefficients en sous-bandes PRMF selon l'option choisie, les possibilités d'adaptation aux évolutions futures en matière de choix des transformations étant de ce fait ouvertes.

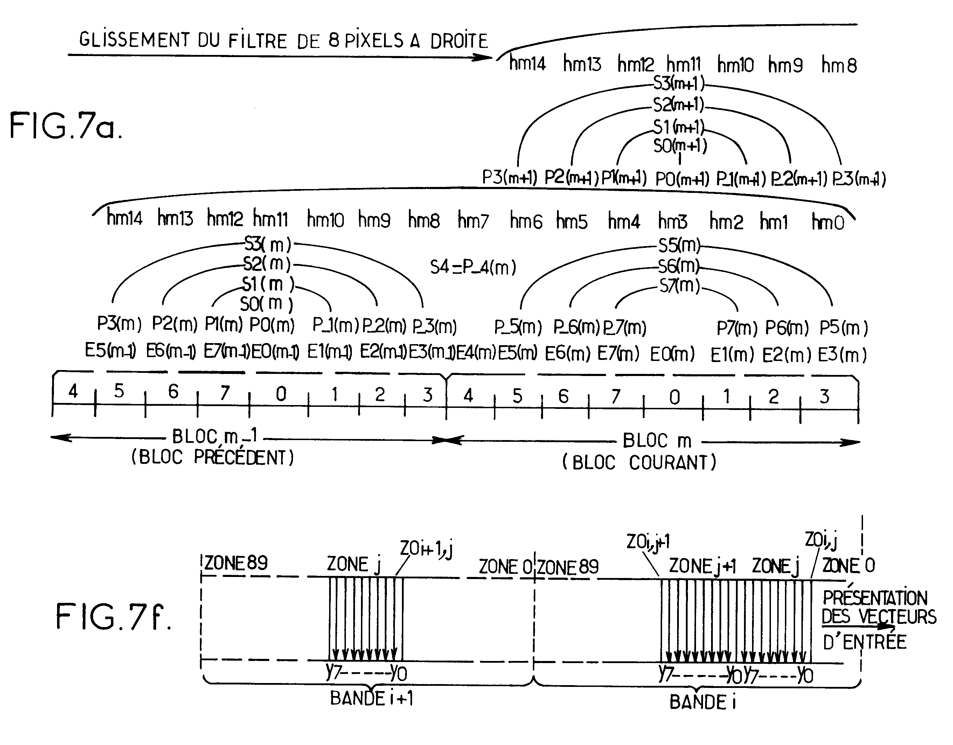

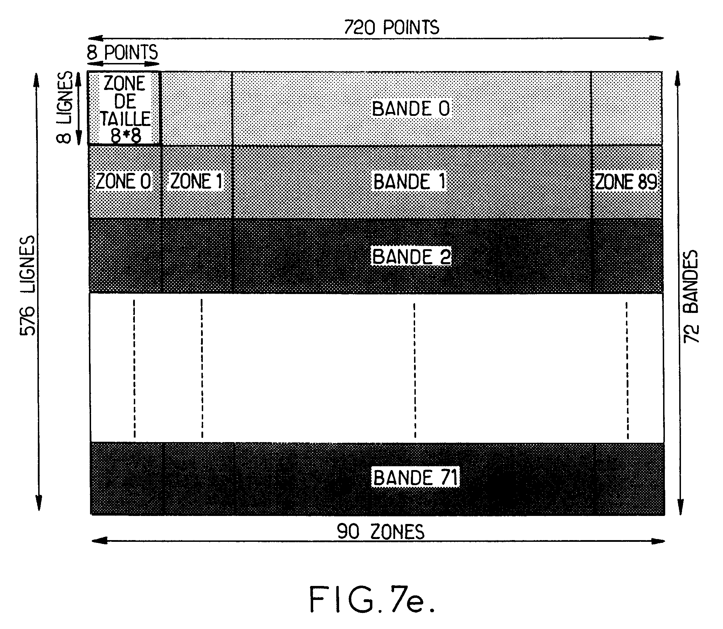

Un mode de réalisation particulier pour une décompo- sition séparable en 8 x 8 sous-bandes, avec SB=8, d'un signal numérique bidimensionnel d'une image de télévision à partir d'un filtre prototype de longueur impaire, NF = 15 = 2.SB-1, sera maintenant donné en liaison avec les figures 7a et suivantes. On note que les données d'entrée, c'est-à-dire les échantillons constitutifs du signal numérique d'entrée sont formés par des blocs de 8x8 pixels dans l'ordre du balayage télévision, comme représenté en figures 7e et 7f.

Sur la figure 7a, on a représenté le processus de filtrage des échantillons d'entrée et de création des signaux préfiltrés selon un filtrage polyphase modifié. On remarquera la notation particulière retenue pour l'indiçage des pixels à l'intérieur des blocs qui assure la cohérence des indices des échantillons d'entrée Ei, des polyphases (ou produits de filtrage) Pi et des valeurs Si (signaux préfiltrés). Cela ne correspond pas à une quelconque permutation des points dans un bloc. La fenêtre de filtrage se présente sur les blocs successifs d'incides m-1 et m telle que l'indique la figure 7a. Sur ces blocs on calcule des sommes $S_i(m)$ de termes $P_i(m)$ et $P_{-i}(m)$ pondérées par un coefficient $2.\sqrt{2}$ ou 2 selon que i est nul ou non. Les termes $S_i(m+1)$ figurant sur ce schéma sont pris en compte pour le traitement du bloc succédant au "bloc courant" ici présenté, et sont obtenus après décalage de huit pixels ou échantillons à droite de la fenêtre de filtrage. On délivre pour chaque bloc courant d'indice m les valeurs de $S_0(m+1)$, $S_1(m+1)$, $S_2(m+1)$, $S_3(m+1)$, $S_4(m)$, $S_5(m)$, $S_6(m)$, $S_7(m)$. Cependant, les résultats $S_0(m+1)$, $S_1(m+1)$, $S_2(m+1)$, $S_3(m+1)$ doivent être mémorisés puisqu'étant soumis à la transformée fréquentielle inverse avec les valeurs $S_4(m+1)$, $S_5(m+1)$, $S_6(m+1)$, $S_7(m+1)$ calculées sur le bloc suivant d'indice m+l. A signaler qu'un gain de mémoire est possible en présentant le pixel EO(m-l) d'un "bloc précédent" à la place du pixel EO(m) non traité du "bloc courant". Le nombre de mémoires nécessaires est alors réduit à trois.

Compte tenu de l'expression de la fonction de transfert du filtre prototype précédemment mentionné, celleci devient :

$$h(n) \;=\; \frac{1}{8.\sqrt{2}} \;\cdot\; \cos\left(\frac{(7-n).\pi}{16}\right)\;,\quad n\in[0,14]$$

On a en outre les valeurs suivantes pour les paramètres précédemment cités dans la description :
$N_0 = 7$, $N_1 = 11$ et $N_2 = 3$.

Les coefficients qui en découlent s'écrivent après renormalisation par 8 :

$$h(0) \;=\; \frac{1}{\sqrt{2}} \sin\frac{\pi}{16}$$

$$h(1) \;=\; \frac{1}{\sqrt{2}} \sin\frac{\pi}{8}$$

$$h(2) \;=\; \frac{1}{\sqrt{2}} \sin\frac{3\pi}{16}$$

$$h(3) \;=\; \frac{1}{2}$$

$$h(4) \;=\; \frac{1}{\sqrt{2}} \cos\frac{3\pi}{16}$$

$$h(5) \;=\; \frac{1}{\sqrt{2}} \cos\frac{\pi}{8}$$

$$h(6) \;=\; \frac{1}{\sqrt{2}} \cos\frac{\pi}{16} \qquad \text{et}$$

$$h(7) \;=\; \frac{1}{\sqrt{2}} \qquad \text{avec } h(14 - n) \;=\; h(n)$$

Des considérations d'antisymétrie des fonctions de transfert Ck(n) et Dk(n) précédemment mentionnées, on peut déduire la nouvelle écriture des valeurs des coefficients de filtrage modifiés hm(n) :
$$hm(n) \;=\; - h(n) \text{ pour } n\leqq2,$$
$$hm(n) \;=\; h(n) \text{ pour } n\geqq3.$$

Les produits de filtrage $P_i(m)$, résultat du filtrage hm appliqué au signal numérique d'entrée, sont obtenus conformément à la mise en oeuvre de la figure 7a de la manière ci-après.

La fenêtre de filtrage se présente sur les blocs successifs d'indices m, m-1, ainsi que représenté sur la figure précitée.

Les résultats du filtrage hm(n) appliqués au signal numérique d'entrée sont représentés par les termes $P_i(m)$, i variant de -7 à 7.

Les signaux $S_i$ désignent les signaux préfiltrés par filtrage polyphase modifié et sont les termes qui sont soumis à la transformée fréquentielle inverse de type DCT de taille 8, dans le processus de transformation directe ou de segmentation.

On obtient ainsi les relations suivantes :

Sur le bloc courant :

$P_5(m) = hm0.E_3(m)$ ; $P_6(m) = hm1.E_2(m)$ ;
$P_7(m) = hm2.E_1(m)$ ; $P_{-7}(m) = hm4.E_7(m)$ ;
$P_{-6}(m)= hm5.E_6(m)$ ; $P_{-5}(m) = hm6.E_5(m)$ ;
$P_{-4}(m) = hm7.E_4(m)$ ; $S_7(m) = 2.(P_7(m)+P_{-7}(m))$ ;
$S_6(m) = 2.(P_6(m)+P_{-6}(m))$ ; $S_5(m) = 2.(P_5(m)+P_{-5}(m))$ ;
$S_4(m) = 2.P_{-4}(m)$

Sur le bloc précédent :

$P_{-3}(m) = hm8.E_3(m-1)$ ; $P_{-2}(m) = hm9.E_2(m-1)$ ;
$P_{-1}(m) = hm10.E_1(m-1)$ ; $P_1(m) = hm12.E_7(m-1)$ ;
$P_2(m) = hm(13).E_6(m-1)$ ; $P_3(m) = hm(14).E_5(m-1)$ ;
$P_0(m) = hm11.E_0(m-1)$ ; $S_1(m) = 2.(P_1(m)+P_{-1}(m))$ ;
$S_2(m) = 2.(P_2(m)+P_{-2}(m))$ ; $S_3(m) = 2.(P_3(m)+P_{-3}(m))$ ;
$S_0(m) = 2.\sqrt{2}.P_0(m)$.

Toutefois, les résultats $S_0(m)$, $S_1(m)$, $S_2(m)$, $S_3(m)$ doivent être mémorisés, ces résultats étant soumis au processus de traitement par transformée fréquentielle inverse de type DCT, avec les valeurs $S_4(m)$, $S_5(m)$, $S_6(m)$, $S_7(m)$ calculées sur le bloc suivant.

Le schéma de principe de l'ensemble du dispositif de segmentation pour le processus de transformation directe ou de segmentation pour le cas où NF=15 et SB=8 est représenté en figure 7b. Le bloc courant de rang m est le bloc traité monodimensionnel de taille 8 pour un traitement séparable. Ce bloc courant correspondant au bloc d'échantillons pour les directions horizontale et verticale de l'image vidéo traitée. On remarque que les valeurs $S_0$, $S_1$, $S_2$ et $S_3$ représentatives du signal préfiltré sur la figure 7b sont issues des traitements opérés sur les blocs précédents grâce à la présence des blocs, notés MEM, permettant la mémorisation des valeurs correspondantes du bloc précédent, soit un retard d'une durée de bloc. Les valeurs indiquées en sortie du filtrage hm correspondent à des facteurs multiplicatifs égaux à $2.\sqrt{2}$ pour le coefficient hm3 et à la valeur 2 pour tous les autres noeuds du filtrage.

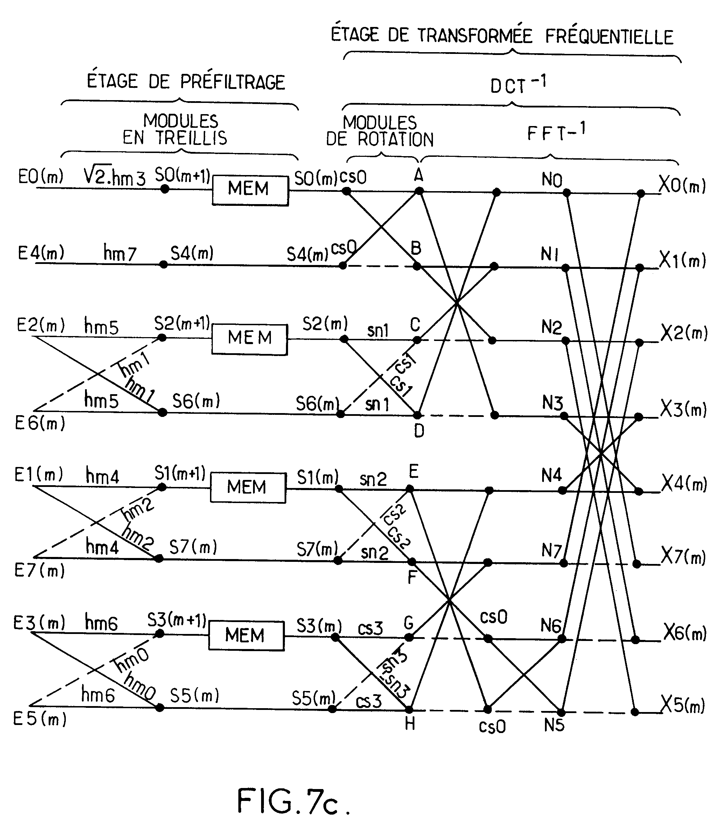

La fonction de transfert du dispositif de segmentation ou de transformation directe telle que représentée en figure 7b est représentée avant simplification en figure 7c. Sur la figure 7c, on remarquera que les coefficients 2 à chaque noeud en sortie du filtrage hm ont été supprimés à des fins de simplification. Bien entendu, ces coefficients peuvent être reportés en fin de traitement.

Un choix particulier pour le processus de traitement par transformée fréquentielle inverse de type DCT est celui permettant de commencer le traitement de transformée inverse précité par un ensemble de treillis de rotation, ces treillis de rotation étant représentés sur la figure 7c entre les signaux préfiltrés $S_0(m)$ à $S_7(m)$ et les points A à H correspondants. Hormis les termes csi et sni ainsi que les coefficients hmn du filtrage hm, les autres notations identifient les différents noeuds sur les différents étages du dispositif de traitement. On notera que les valeurs prises par les coefficients csi et sni se déduisent directement des coefficients utilisés dans une transformée fréquentielle inverse de type DCT de taille 8, ces valeurs étant les suivantes :

$$cs0 = \cos\pi/4 = \frac{1}{\sqrt{2}} \; ; \; cs1 = \cos\pi/8 \; ; \; cs2 = \cos\pi/16 \; ;$$

$cs3 = \cos3\pi/16$ ; $sn1 = \sin\pi/8$ ; $sn2 = \sin\pi/16$ ; $sn3 = \sin3\pi/16$.

On remarquera enfin que les signaux préfiltrés obtenus après préfiltrage par filtrage de type polyphase modifié sur le bloc précédent et amenés à être utilisés sur le bloc courant, portent la référence (m) indiquant simplement l'indice du bloc courant.

La transformation des différents modules en cascade consistant en modules en treillis de filtrage hm précédemment mentionnés et modules de mémorisation, constituant en fait l'étage de préfiltrage de type polyphase modifié lorsque ceux-ci sont associés avec les fonctions de mémorisation correspondantes sur un bloc, ainsi que décrit précédemment dans la description, et modules de rotation d'entrée de la transformée fréquentielle inverse précédemment décrits, les signaux obtenus aux points A à H précédemment mentionnés peuvent s'écrire en prenant :

$$V1(m + 1) = a/\alpha.E_1(m) - b/\alpha.E_7(m)$$

avec a=hm4 b=hm2 c=sn2 d=cs2

**14**

et en prenant par exemple $\alpha = 1/d$ et en posant :

$$a1 = \frac{1}{\sqrt{2}} \cdot \cos\frac{\pi}{16} \cdot \cos\frac{3\pi}{16}$$

$$b1 = \frac{1}{\sqrt{2}} \cdot \cos\frac{\pi}{16} \cdot \sin\frac{3\pi}{16}$$

$$c1 = \tan g\frac{\pi}{16}$$

$$V1(m + 1) = \alpha1.E_1(m) + b1.E_7(m)$$

$$E = \frac{E_1(m) - E_7(m)}{2} + (V1(m) - V1(m + 1)).c1$$

$$F = \frac{E_1(m) + E_7(m)}{2} + (V1(m) - V1(m + 1))$$

relation dans laquelle l'indice m, m+1 indique l'indice des blocs correspondants.

De la même manière, les signaux obtenus en G et H s'écrivent avec $V3(m+1) = a/\alpha.E_3(m) - b/\alpha.E_5(m)$ en posant a=hm6, b=hm0, c=cs3, d=-sn3 et en prenant $\alpha = \frac{1}{c}$, en posant en outre :

$$b3 = \frac{1}{\sqrt{2}} \cdot \cos\frac{\pi}{16} \cdot \cos\frac{3\pi}{16}$$

$$a3 = \frac{1}{\sqrt{2}} \cdot \sin\frac{\pi}{16} \cdot \cos\frac{3\pi}{16}$$

$$c3 = -\tan g\frac{3\pi}{16}$$

$$V3(m + 1) = a3.E_5(m) + b3.E_3(m)$$

$$G = \frac{E_5(m) + E_3(m)}{2} + (V3(m) - V3(m + 1))$$

$$H = \frac{E_5(m) - E_3(m)}{2} + (V3(m) - V3(m + 1)).c3$$

Les signaux obtenus en C et D en fonction de $E_2(m)$ et $E_6(m)$ s'expriment de la même façon après réduction en prenant $V2(m+1) = a/\alpha.E_2(m) - b/\alpha.E_6(m)$, avec a=hm5, b=hm1, c=sn1, d=cs1, et $\alpha = 1/d$ en posant :

$$a2 = \frac{1}{\sqrt{2}} \cdot \cos\frac{\pi}{8} \cdot \cos\frac{\pi}{8}$$

$$b2 = \frac{1}{\sqrt{2}} \cdot \cos\frac{\pi}{8} \cdot \sin\frac{\pi}{8} = \frac{1}{4}$$

$$c2 = \tan g\frac{\pi}{8}$$

$$V2(m + 1) = a2.E_2(m) + \frac{E_6(m)}{4}$$

$$C = \frac{E_2(m) - E_6(m)}{2} + (V2(m) - V2(m + 1)).c2$$

$$D = \frac{E_2(m) + E_6(m)}{2} + (V2(m) - V2(m + 1))$$

Enfin, les signaux obtenus en A et B en fonction de $E_0(m)$ et $E_4(m)$ s'écrivent avec
$$cs0 = 1/\sqrt{2}, \quad hm11 = 1/2, \quad hm7 = 1/\sqrt{2}$$
$$A = 1/2 (S_0(m) + S_4(m))$$
$$B = 1/2 (S_0(m) - S_4(m)).$$

D'une manière avantageuse, on note la similarité existant entre les fonctions représentées après réduction pour l'obtention des signaux CD ; EF ; GH et AB, ce qui permettra de faciliter la réalisation du dispositif de segmentation objet de la présente invention sous forme de circuit intégré, ainsi qu'il sera décrit ultérieurement dans la description.

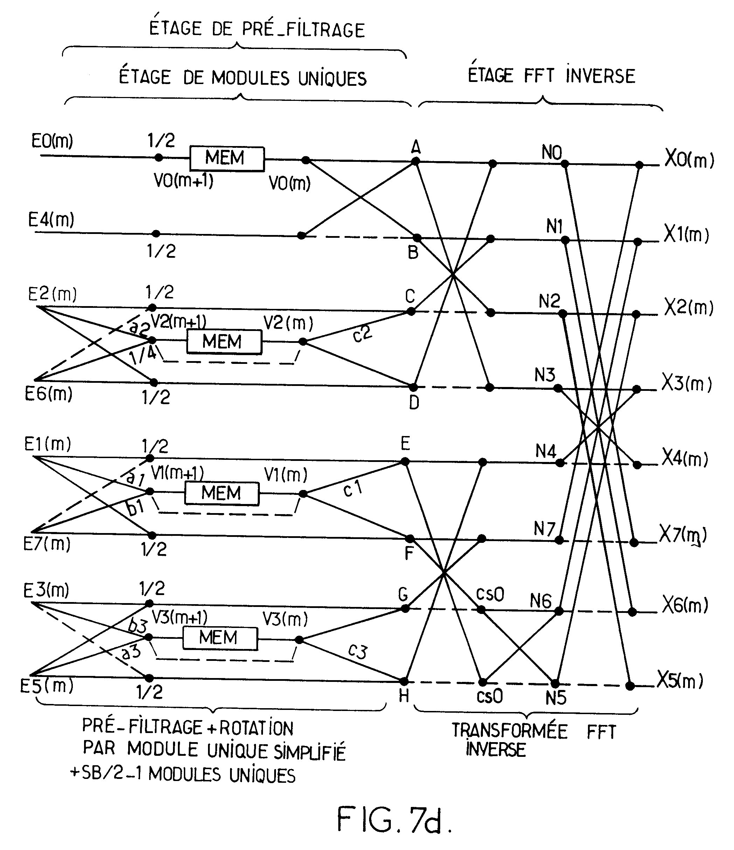

La représentation globale au moyen des modules uniques simplifiés précédemment décrits pour le processus de transformation directe selon une direction X ou Y exercée sur un bloc de 8 pixels d'image vidéo, conduit au schéma global représenté en figure 7d, les modules uniques étant agencés en parallèle de façon à constituer en fait l'étage de préfiltrage des échantillons ainsi que représenté sur la figure précitée. Sur la figure 7d, et pour le mode de réalisation représenté en figures 7b, 7c et 7d du dispositif de segmentation objet de la présente invention, dans le cas particulier où NF=15 et SB=8, on comprend que les notations utilisées correspondent aux notations précédemment mentionnées dans les figures 6c, 6d et 6e :

$A = e_0$ ; $B = f_0$ ; $C = e_2$ ; $D = f_2$ ;

$E = e_1$ ; $F = f_1$ ; $G = e_3$ ; $H = f_3$.

On notera que les opérations successives à partir des signaux A à H précédemment mentionnés pour l'obtention des signaux $N_0$ à $N_7$, puis finalement en composante en sous-bandes $X_0(m)$ à $X_7(m)$ correspondent à des transformations opérées par des modules papillon de type classique, lesquels ne seront pas décrits en détail.

Ainsi, pour la segmentation en sous-bandes dans le cas et le mode de réalisation précités, le coût en opération pour l'obtention des points ou signaux A à H à partir des échantillons $E_0$ à $E_7$ est de 20 additions et 8 multiplications, le coût pour l'obtention des signaux $N_0$ à $N_7$ à partir des signaux A à H est de 10 additions et 2 multiplications, et le coût des opérations pour l'obtention des signaux en sous-bandes $X_0$ à $X_7$ à partir des signaux $N_0$ à $N_7$, est de 8 additions.

Le coût global pour la segmentation en 8 sous-bandes d'un bloc de 8 pixels, dans le cadre précité, est donc de 38 additions et 10 multiplications.

Afin d'effectuer le traitement des signaux numériques d'entrée tels que précédemment mentionnés, l'image ainsi que représentée en figure 7e peut être partagée en bandes de largeur 8 pixels parcourues selon un balayage de gauche à droite et décomposées chacune en zones de taille 8 x 8, par exemple.

A titre d'exemple, une image au format 720 points/ligne et 576 lignes est décomposée en 72 bandes de 8 lignes chaque bande étant décomposée en 90 zones de taille 8 x 8. Le circuit réalisant en premier lieu le traitement vertical, il convient de présenter les données d'entrée sous forme de vecteurs verticaux (une zone de taille 8 x 8 sera donc composée de 8 vecteurs verticaux de taille 8 x 1).

Le circuit reçoit en entrée des zones de 8 x 8 pixels qu'il organise en 8 vecteurs verticaux de 8 pixels. Pour chaque zone, on réalise avantageusement la transformation précédemment décrite successivement selon la direction Y puis, après transposition, selon la direction X (Transformation séparable). Le schéma de la figure 7f présenté ci-dessous illustre ce mode de réception des données d'entrée sous forme de blocs vectorisés suivant la direction Y.

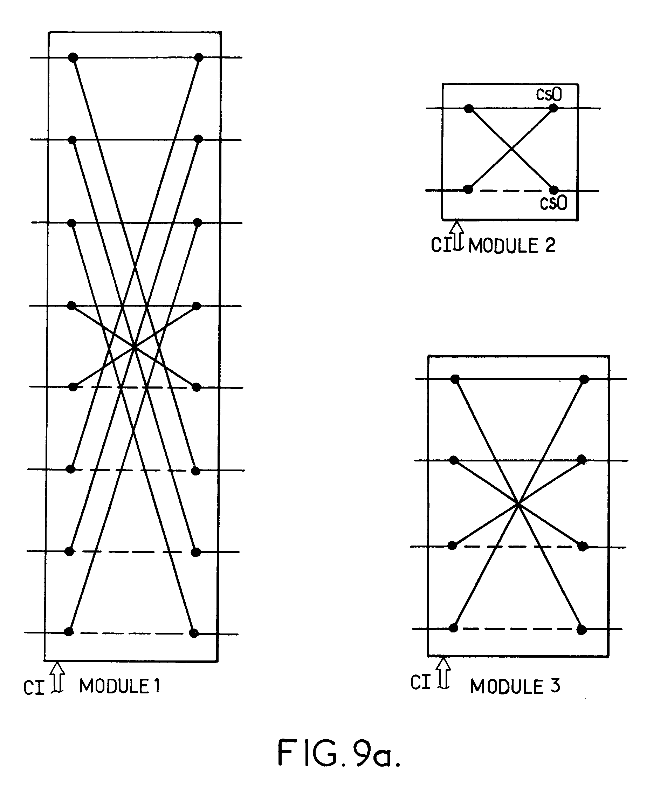

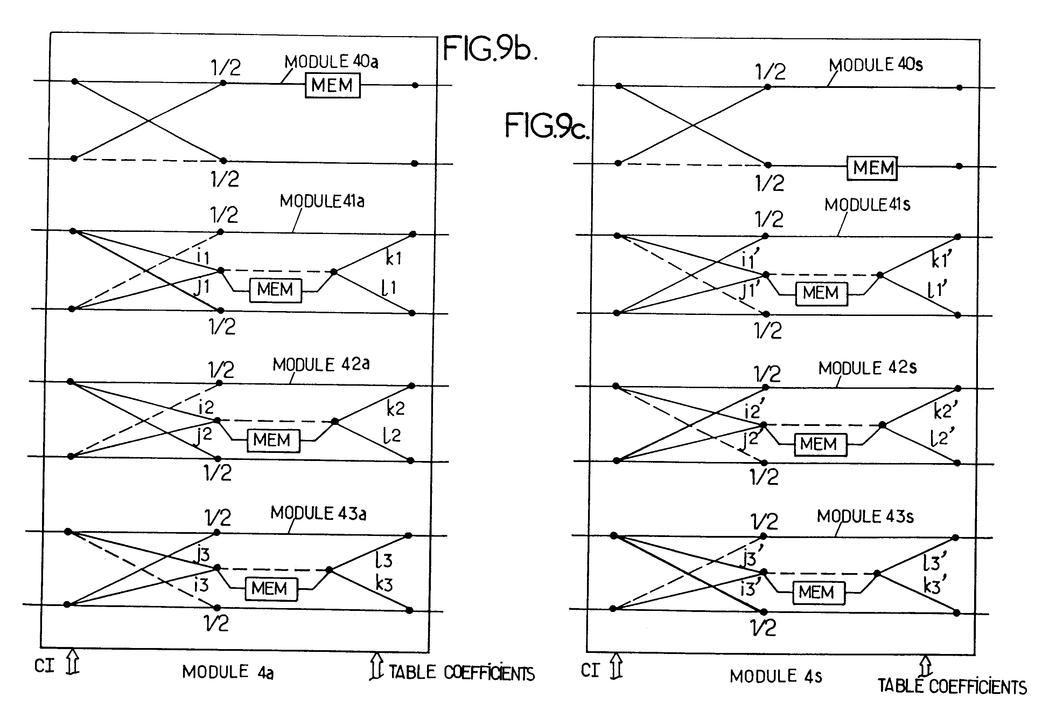

Sur la figure précitée, chaque flèche pointée vers le bas (notation du type Yk, k prenant les valeurs 0 à 7) représente un vecteur vertical de taille 8∗1 pixels, 8 vecteurs Y0 à Y7 constituant une zone de taille 8 X 8. On balaie donc les bandes de chaque image précédemment définies dans l'ordre croissant de leur indice (bande 0 à bande 71), la zone 0 à la zone 89 (voir figure 9a), afin de délivrer au circuit une suite de vecteurs verticaux successifs constituant ces blocs (voir figure 9b). Le circuit débute ainsi son traitement suivant la direction verticale, selon les considérations précédentes.

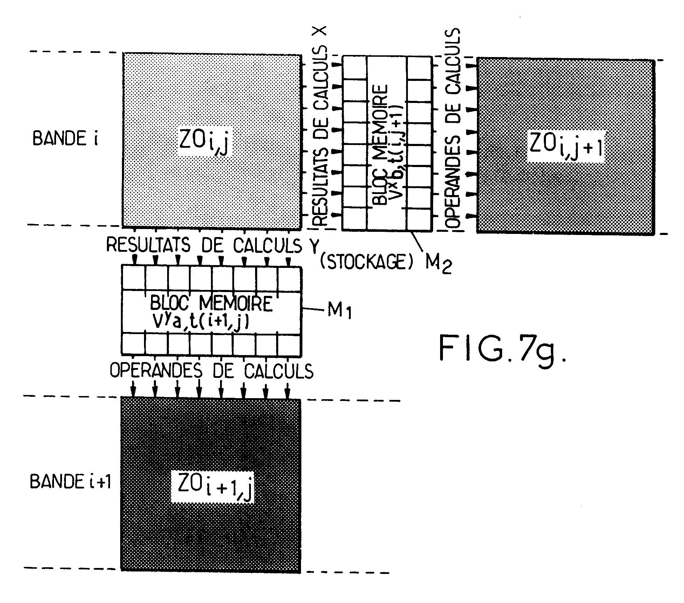

Compte tenu du dispositif représenté en figure 7d, dans le cas monodimensionnel et des mémorisations indiquées, valeurs $V_i(m+1)$ dans le cas bidimensionnel et selon le balayage ci-avant retenu, on doit mémoriser 4 lignes pour le traitement vertical et 8 fois 4 pixels pour le traitement horizontal ainsi qu'illustré sur la figure 7g.

Le dispositif de segmentation reçoit alors en entrée des zones de 8 x 8 pixels qu'il permet d'organiser en 8 vecteurs verticaux de 8 pixels. Pour chaque zone, on réalise ainsi pour la transformation de segmentation un balayage selon la direction Y puis selon la direction X, dans le cas d'un traitement en mode séparable. Les pixels d'entrée sont représentés sur 9 bits, dont un bit de signe, et les calculs internes de multiplication et d'addition précités peuvent être effectués dans des registres de largeur 16 bits.

En ce qui concerne les valeurs V0, V1, V2, et V3 calculées sur une zone j d'une bande i, notée $Z0_{i,j}$. et pour un vecteur Ya pour la transformation verticale, celles-ci sont mémorisées jusqu'au traitement du bloc j de la bande suivante i+1 pour le vecteur Ya, $a \in [0,SB-1]$.

En effet, en reprenant les notations de la figure 7g, on constate que pour chaque zone j d'une bande i sont engendrés :

-> pour le traitement en Y, une zone $V^y_{a,t}(i+1, j)$ où sont rangées les 8 fois $(a \in [0,73])$"4 valeurs $V_t(t=0,1,2,3)$" réutilisées par les vecteurs Ya de la zone j de la bande i+1,

-> pour le traitement en X, une zone $V^x_{b,t}(i,j+1)$ où sont rangées les 8 fois "4 valeurs $V_t(j+1)$ (pour t=0,1,2,3)" réutilisées par la zone j+1 de la bande i.

Il est donc nécessaire de prévoir une mémoire M1 de (4∗NP∗NbitY) bits pour le traitement en Y (NP représentant le nombre de points par ligne soit 720 dans notre exemple, et NbitY représentant la précision en nombre de bits pour stocker ces valeurs) et d'une mémoire M2 de (4∗8∗NbitX) bits pour le traitement en X (NbitX représentant la précision en nombre de bits pour stocker ces valeurs). Des lignes à retard de longueur NP en traitement vertical et de longueur 8 en traitement horizontal, opérant sur des mots de NbitY et NbitX respectivement, peuvent remplacer ces mémoires, avec l'avantage de n'avoir à effectuer aucune gestion d'adresses.

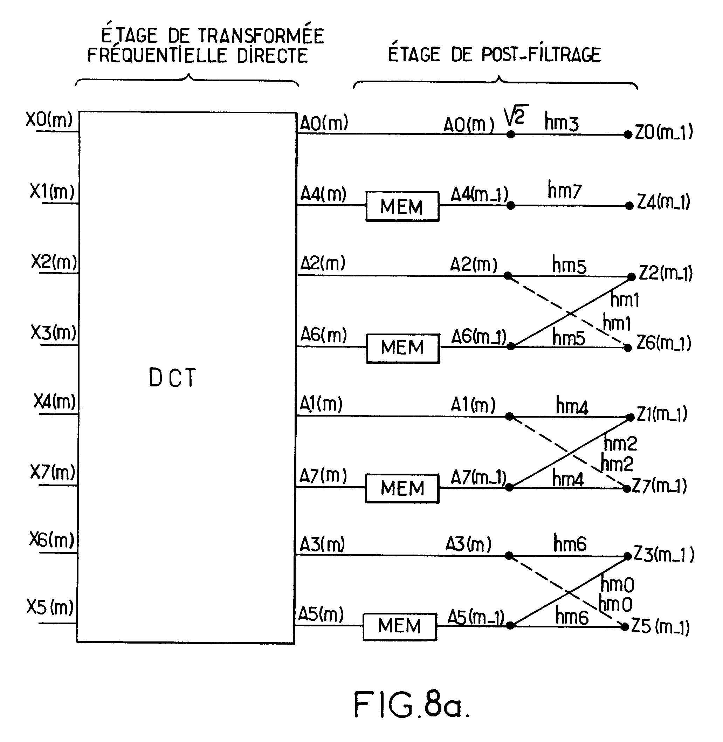

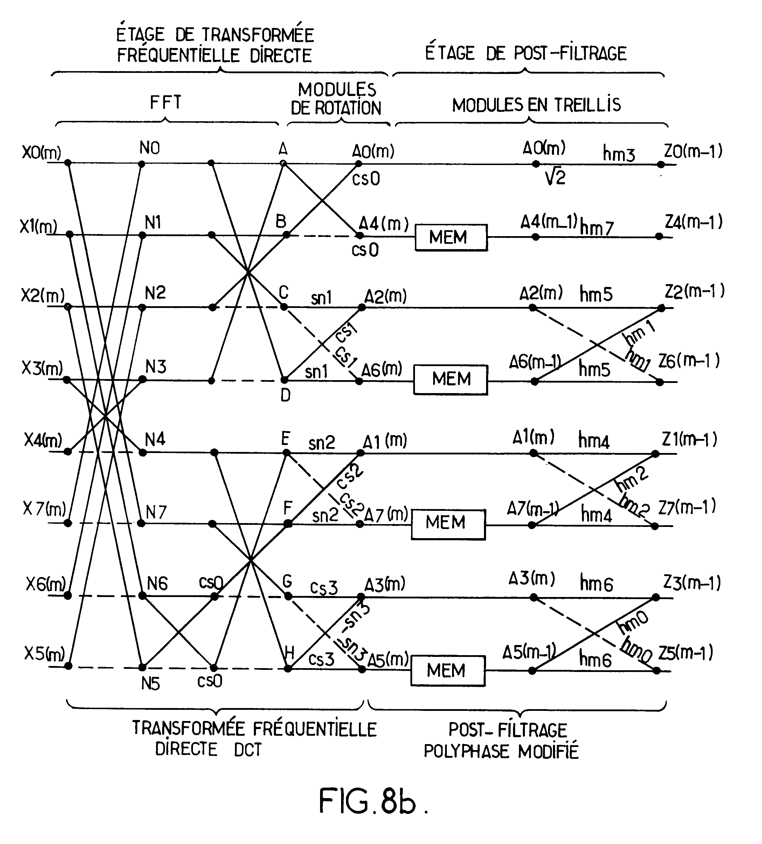

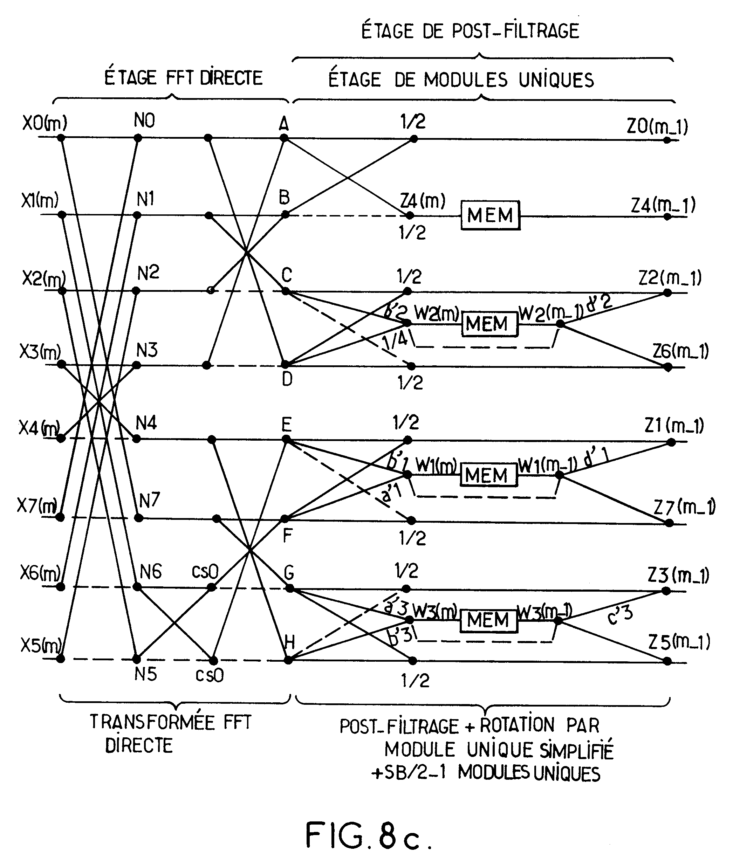

Une description plus détaillée d'un dispositif de reconstruction ou de transformation inverse dans le même cas où le banc de filtre comporte NF=15 coefficients et où les signaux en sous-bandes sont au nombre de 8, $X_0$ à $X_7$ sera donnée en liaison avec les figures 8a, 8b et 8c.

Pour la suite de l'exposé, on utilise la notation ci-après :

On note Zi(m) la sortie i pour le bloc d'échantillons correspondants m, avec là encore l'indiçage suivant dans un bloc m : $Z_4$, $Z_5$, $Z_6$, $Z_7$, $Z_0$, $Z_1$, $Z_2$, $Z_3$.

On désigne par As(m) le $s^{ième}$ coefficient de la DCT opérée sur les composantes en sous-bandes Xk(m), $k \in [0, SB-1]$.

Les termes de reconstruction sont pondérés par le facteur $\frac{SB}{\delta(s)}$ afin de mettre en évidence auparavant une forme de DCT. On devra donc tenir compte de ce terme dans les équations qui vont suivre, et notamment pour $Z_0(m)$ où devra apparaître le coefficient multiplicatif $\sqrt{2}$ correspondant à $\frac{1}{\delta(0)}$.

En considération des notations ci-dessus, on dispose ainsi du jeu d'équations suivant pour réaliser la transformation inverse à partir des composantes ou signaux en sous-bandes $X_k(m)$ :

$$
\begin{bmatrix} Z_s(m-1) \\ Z_{SB-s}(m-1) \end{bmatrix} = \frac{1}{\delta(s)} \begin{bmatrix} h_{3+s} & -h_{3-s} \\ h_{3-s} & h_{3+s} \end{bmatrix} \begin{bmatrix} A_s(m) \\ A_{SB-s}(m-1) \end{bmatrix},
$$

$s \in [0, \frac{SB}{2}-1]$, ou de façon équivalente :

$$
\begin{bmatrix} Z_s(m-1) \\ Z_{SB-s}(m-1) \end{bmatrix} = \frac{1}{\delta(s)} \begin{bmatrix} hm_{3+s} & hm_{3-s} \\ -hm_{3-s} & hm_{3+s} \end{bmatrix} \begin{bmatrix} A_s(m) \\ A_{SB-s}(m-1) \end{bmatrix}
$$

et finalement comme $h_s = \frac{1}{\sqrt{2}} . \cos\frac{(s-7).\pi}{2.SB}$ avec SB=8,

on obtient :

$$
\begin{bmatrix} Z_s(m-1) \\ Z_{SB-s}(m-1) \end{bmatrix} = \frac{1}{\delta(s)\sqrt{2}} \begin{bmatrix} \cos[\frac{(4-s).\pi}{16}] & -\sin[\frac{(4-s).\pi}{16}] \\ \sin[\frac{(4-s).\pi}{16}] & \cos[\frac{(4-s).\pi}{16}] \end{bmatrix} \begin{bmatrix} A_s(m) \\ A_{SB-s}(m-1) \end{bmatrix},
$$

$s \in [0, \frac{SB}{2}-1]$

et pour s=SB/2, on a

$$Z_4(m-1) = h7.A_4(m-1),$$

soit

$$Z_4(m-1) = \frac{1}{\sqrt{2}}.A_4(m-1).$$

La transformation inverse, ou le processus de reconstruction à partir des composantes en sous-bandes $X_0(m)$ à $X_7(m)$ peut alors être exprimée de la manière ci-après, suite à des considérations analogues à celles relatives au processus de segmentation.

Dans les développements ci-après, on désigne par DCT(m,s) le s/ième coefficient de la transformée fréquentielle DCT opérée sur les m ième échantillons, ou pixels pris dans les 8 sous-bandes de fréquences précédemment citées.

Les termes de reconstruction sont pondérés par le facteur $\frac{SB}{\delta(s)}$

- pour s=0 et s=4, la composante de signal reconstruit ou sortie $Z_s(m-1)$ correspondante s'écrit :

$$Z_s(m-1) = h(3+s).DCT(m,s).\frac{1}{\delta(s)} ;$$

on notera que le coefficient $\dfrac{1}{\delta(s)}$ a dans ce cas la valeur $\sqrt{2}$ pour s=0 et 1 sinon ;

- pour $1 \leqq s \leqq 3$, en tenant compte de l'expression de :

$$Z_s(m-1) = h(3+s).DCT(m,s)+h(3+SB+s).DCT(m-1,SB-s)$$ et de l'expression correspondante sur le bloc antérieur m-1 :

$$Z_{SB\cdot s}(m-1) = h(3+SB-s).DCT(m-1, SB-s) + h(3-s).DCT(m,s),$$

et avec

$$h(3+s) = \frac{1}{SB.\sqrt{2}}.\cos\left(\frac{(s-4).\pi}{2.SB}\right)$$

relations dans laquelle h représente les coefficients du filtre prototype correspondant. Les expressions des composantes de signal reconstruit vérifient les relations :

$$Z_s(m-1) = \frac{1}{\sqrt{2}}\left[\cos\left(\frac{(4-s).\pi}{16}\right).DCT(m,s) - \sin\left(\frac{(4-s).\pi}{16}\right).DCT(m-1,8-s)\right]$$

$$Z_{SB-s}(m-1) = \frac{1}{\sqrt{2}}\left[\sin\left(\frac{(4-s).\pi}{16}\right).DCT(m,s) + \cos\left(\frac{(4-s).\pi}{16}\right).DCT(m-1,8-s)\right]$$

De la même manière que dans la transformation directe, on ne tient pas compte du rapport 1/SB afin de conserver une dynamique maximale dans le circuit.

Une correction correspondante doit cependant être apportée à l'issue du dernier étage afin de prendre en compte cette normalisation précédente.

On constate ainsi que de manière duale au dispositif de segmentation représenté en figure 7b, le dispositif de reconstruction objet de l'invention, tel que représenté en figure 8a comprend un étage de transformée fréquentielle, de type DCT, suivi d'un étage de post-filtrage formé par des modules de mémorisation suivi de modules en treillis, ainsi qu'il sera décrit ci-après.

La fonction de transfert globale du circuit représenté en figure 8a est elle-même représentée en figure 8b avec les relations ci-après. On remarque que les relations qui vont suivre utilisent les mêmes notations que celles utilisées dans le processus de transformation directe pour désigner les coefficients intervenant dans les modules en treillis.

Les différentes composantes de signal reconstruit s'écrivent :

$$Z_0(m-1) = \sqrt{2}.DCT(m,0).hm3 = \sqrt{2}.hm3.A_0(m)$$
$$Z_4(m-1) = DCT(m,4).hm7 = hm7.A_4(m-1)$$

$$Z_1(m-1) = \frac{1}{\sqrt{2}}.\left[\cos\left(\frac{3\pi}{16}\right).DCT(m,1) - \sin\left(\frac{3\pi}{16}\right).DCT(m-1,7)\right]$$
$$= hm4.A_1(m) + hm2.A_7(m-1)$$

$$Z_7(m-1) = \frac{1}{\sqrt{2}}.\left[\sin\left(\frac{3\pi}{16}\right).DCT(m,1) + \cos\left(\frac{3\pi}{16}\right).DCT(m-1,7)\right]$$
$$= -hm2.A_1(m) + hm4.A_7(m-1)$$

$$Z_2(m-1) = \frac{1}{\sqrt{2}}.\left[\cos\left(\frac{\pi}{8}\right).DCT(m,2) - \sin\left(\frac{\pi}{8}\right).DCT(m-1,6)\right]$$
$$= hm5.A_2(m) + hm1.A_6(m-1)$$

$$Z_6(m-1) = \frac{1}{\sqrt{2}} \cdot [\sin\left(\frac{\pi}{8}\right) \cdot DCT(m,2) + \cos\left(\frac{\pi}{8}\right) \cdot DCT(m-1,6)]$$
$$= -hm1 \cdot A_2(m) + hm5 \cdot A_6(m-1)$$

$$Z_3(m-1) = \frac{1}{\sqrt{3}} \cdot [\cos\left(\frac{\pi}{16}\right) \cdot DCT(m,3) - \sin\left(\frac{\pi}{16}\right) \cdot DCT(m-1,5)]$$
$$= hm6 \cdot A_3(m) + hm0 \cdot A_5(m-1)$$

$$Z_5(m-1) = \frac{1}{\sqrt{3}} \cdot [\sin\left(\frac{\pi}{16}\right) \cdot DCT(m,3) + \cos\left(\frac{\pi}{16}\right) \cdot DCT(m-1,5)]$$
$$= hm6 \cdot A_5(m-1) - hm0 \cdot A_3(m-1)$$

Sur la figure 8b, on constate que les valeurs des signaux numériques désignées $A_0(m)$ à $A_7(m)$ constituent en fait les composantes en sous-bandes $Xk(m)$ en entrée du circuit représenté en figure 8a auxquelles ont été appliquée la transformée fréquentielle directe de type DCT. Au contraire, les signaux numériques $Z_0(m)$ à $Z_7(m)$, que ceux-ci soient sur le bloc courant ou sur le bloc précédent, correspondent alors aux signaux de transformée fréquentielle directe $A_0(m)$ à $A_7(m)$ précités auxquels a été appliqué le processus de postfiltrage de type polyphase modifié. Ces signaux $Z_0(m)$ à $Z_7(m)$ constituent ainsi les composantes de signal reconstruit $Rec(n)$. Bien entendu, et de manière analogue au dispositif relatif à la segmentation, les blocs mémoire MEM, constituant les modules mémorisation, permettent d'effectuer une mémorisation des signaux intermédiaires avec un retard d'un bloc au bloc suivant.

Sur la figure 8b, les coefficients indiqués à proximité des noeuds correspondent à des coefficients multiplicatifs, les lettres désignant les signaux aux noeuds correspondants.

Un raisonnement similaire à celui présentement établi dans le cas de la transformation directe, ou de segmentation, permet de constater que les coefficients des modules en treillis de sortie, c'est-à-dire placés après les blocs de mémorisation MEM, se retrouvent aussi associés aux modules en treillis de rotation de la transformée fréquentielle directe DCT. Ceci à une normalisation près en $\sqrt{2}$ à l'analyse et à la synthèse dans le filtre prototype h. Cette constatation permet d'envisager la conception d'un circuit intégré susceptible de présenter l'avantage de posséder les mêmes treillis dupliqués ou encore des treillis travaillant à vitesse double et réalisant donc les deux opérations de postfiltrage et de rotation de sortie de transformée fréquentielle DCT directe.

Les valeurs prises par les coefficients cs0 à cs3 et sn0 à sn3, valeurs précisées lors de l'étude de la transformation directe dans le cadre du dispositif de segmentation, se déduisent directement des coefficients utilisés dans une transformée fréquentielle de type DCT directe de taille 8.

Les coefficients présents sur la figure 8b ont été définis dans la partie relative à l'étude de la transformation directe précédemment dans la description.

Une démarche analogue à celle ayant conduit à la définition d'un dispositif de segmentation tel que représenté en figure 7d, dans lequel des modules uniques sont agencés en parallèle de façon à constituer le dispositif de segmentation, peut être conduite relativement au dispositif de reconstruction, celui-ci étant alors formé de modules uniques agencés en parallèle de façon à constituer l'étage de postfiltrage complété par les modules en treillis de rotation de l'étage de sortie de transformée fréquentielle, ainsi que représenté en figure 8c. Chaque unité comporte pour un nombre de coefficients de filtres impair NF=15, dans l'exemple de réalisation donné avec la figure 8c, un module unique simplifié délivrant les composantes de signaux reconstruits $Z_0(m-1)$ et $Z_4(m-1)$ et d'une pluralité de $\frac{SB}{2}-1$ modules uniques délivrant les signaux reconstruits respectivement $Z_2(m-1)$, $Z_6(m-1)$, $Z_1(m-1)$, $Z_7(m-1)$, $Z_3(m-1)$ et $Z_5(m-1)$. On notera bien entendu que, de manière duale au module de décomposition en sous-bandes, le module de reconstruction tel que représenté en figure 8c comporte un étage de transformée fréquentielle de type FFT directe associé à l'étage de modules uniques, ainsi qu'il sera explicité ci-après.

Avec des notations semblables à celles déjà utilisées en relation avec la figure 7d, les composantes de signal reconstruit s'écrivent successivement :

$$Z_0(m - 1) = \frac{1}{\sqrt{2}} (A + B) \cdot \sqrt{2} \cdot hm3 = \frac{A + B}{2}$$
$$Z_4(m) = \frac{1}{\sqrt{2}} (A - B) \cdot hm7 = \frac{A - B}{2}$$

En outre,
- pour $Z_1(m-1)$ et $Z_7(m-1)$ :
avec

$$a = sn2 = \sin\frac{\pi}{16}$$

$$b = cs2 = \cos\frac{\pi}{16}$$

$$c = hm4 = \frac{1}{\sqrt{2}}.\cos\frac{3\pi}{16}$$

$$d = hm2 = -\frac{1}{\sqrt{2}}.\sin\frac{3\pi}{16}$$

en prenant par exemple $\alpha = 1/c$,
on obtient, en posant

$$a'1 = \frac{1}{\sqrt{2}}.\sin\frac{\pi}{16}.\cos\frac{3\pi}{16}$$

$$b'1 = -\frac{1}{\sqrt{2}}.\cos\frac{3\pi}{16}.\cos\frac{\pi}{16}$$

$$c'1 = 1$$

$$d'1 = -\text{tang}\frac{3\pi}{16}$$

$$W_1(m) = a'1.F + b'1.E$$

$$Z_1(m-1) = \frac{F+E}{2} + (W_1(m-1) - W_1(m)).d'1$$

$$Z_7(m-1) = \frac{F-E}{2} + (W_1(m-1) - W_1(m))$$

- et pour $Z_3(m)$ et $Z_5(m)$ :
avec

$$a = cs3 = \cos\frac{3\pi}{16}$$

$$b = -sn3 = -\sin\frac{3\pi}{16}$$

$$c = hm6 = \frac{1}{\sqrt{2}}.\cos\frac{\pi}{16}$$

$$d = hm0 = -\frac{1}{\sqrt{2}}.\sin\frac{\pi}{16}$$

et en prenant par exemple $\alpha = 1/c$,
on obtient, en posant

$$b'3 = \frac{1}{\sqrt{2}}.\cos\frac{3\pi}{16}.\cos\frac{\pi}{16}$$

$$a'3 = \frac{1}{\sqrt{2}}.\sin\frac{3\pi}{16}.\cos\frac{\pi}{16}$$

$$c'3 = -\text{tang}\frac{\pi}{16}$$

$$d'3 = 1$$

$$W_3(m) = a'3.G + b'3.H$$

$$Z_3(m-1) = \frac{G-H}{2} + (W_3(m-1) - W_3(m)).c'3$$

$$Z_5(m-1) = \frac{G+H}{2} + (W_3(m-1) - W_3(m))$$

- et pour $Z_2(m-1)$ et $z_6(m-1)$ :
avec

$$a = sn1 = \sin\frac{\pi}{8}$$

$$b = cs1 = \cos\frac{\pi}{8}$$

$$c = hm5 = \frac{1}{\sqrt{2}}.\cos\frac{\pi}{8}$$

$$d = hm1 = -\frac{1}{\sqrt{2}}.\sin\frac{\pi}{8}$$

et en prenant par exemple $\alpha = 1/c$,
on obtient, en posant

$$a'2 \ = \ \frac{1}{\sqrt{2}}.\cos\frac{\pi}{8}.\sin\frac{\pi}{8} \ = \ \frac{1}{4}$$

$$b'2 \ = \ -\frac{1}{\sqrt{2}}.\cos\frac{\pi}{8}.\cos\frac{\pi}{8}$$

$$c'2 \ = \ 1$$

$$d'2 \ = \ -\,tg\frac{2\pi}{8}$$

$$W_2(m) \ = \ b'2.C \ + \ \frac{D}{4}$$

$$Z_2(m-1) \ = \ \frac{D+C}{2} \ + \ (W_2(m-1) - W_2(m)).d'2$$

$$Z_6(m-1) \ = \ \frac{D-C}{2} \ + \ (W_2(m-1) - W_2(m)).$$

Une observation des figures 7d et 8c précédemment décrites montre la similarité existant entre l'ensemble des fonctions représentées précédemment tant dans le dispositif de segmentation que dans le dispositif de reconstruction représenté et décrit en relation avec les figures précitées. Une telle similarité permet de faciliter l'implantation de ces circuits et dispositifs de tranformation dans le sens direct respectivement inverse lorsque des filtres PRMF ou CPRMF sont utilisés, notamment sous forme de circuit intégré.

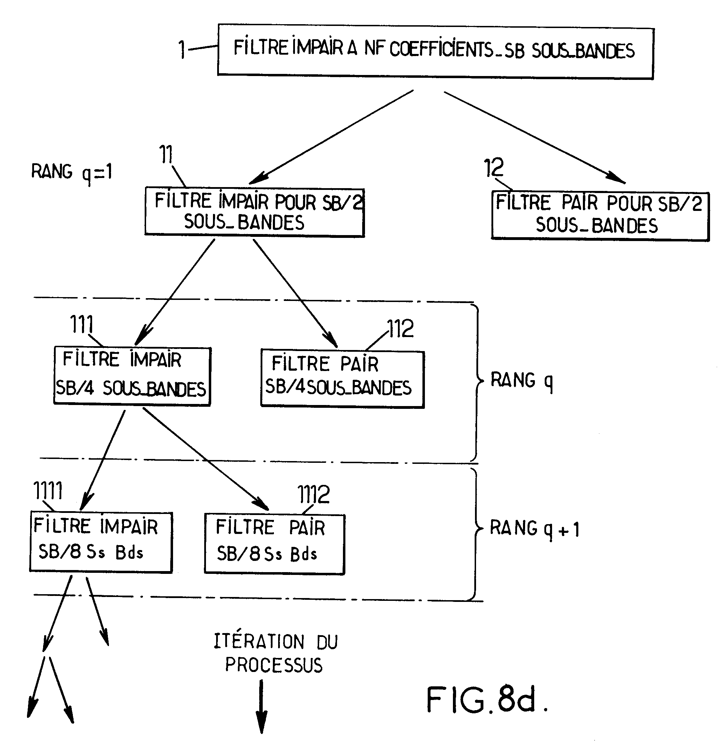

En premier lieu, l'observation des figures 7d et 8c, relatives au dispositif de segmentation reconstruction objet de l'invention, montre que les fonctions de transfert correspondantes contiennent comme sous-parties les fonctions de transfert élémentaires pour NF = 7 et SB = 4, partie $E_0(m)$, $E_2(m)$, $E_4(m)$, $E_6(m)$ à $N_0$, $N_1$, $N_2$, $N_3$ respectivement $N_0$, $N1$, $N_2$, $N_3$ et $Z_0(m)$, $Z_4(m)$, $Z_2(m)$, $Z_6(m)$ ainsi que pour NF = 8 et SB = 4, partie $E_1(m)$, $E_3(m)$, $E_5(m)$, $E_7(m)$ à $N_4$, $N_5$, $N_6$, $N_7$, respectivement $N_4$, $N_5$, $N_6$, $N_7$ à $Z_1(m)$, $Z_3(m)$, $Z_5(m)$ et $Z_7(m)$. Bien entendu, pour SB égal à un multiple de 2 et NF impair, le processus peut être réitéré sur chaque branche pour un filtre PRMF impair, ainsi qu'il sera décrit ci-après en liaison avec la figure 8d dans le cas général.

Le filtre prototype h(n) est alors subdivisé selon une première subdivision de rang q, q=1 par exemple, en un premier et en deuxième filtres élémentaires, obtenus en prenant un coefficient sur deux du filtre h(n), c'est-à-dire en choisissant n pair ou impair. Sur la figure 8d, on a représenté une telle subdivision, le filtre impair à NF coefficients pour le traitement de SB sous-bandes étant noté 1, le premier et le deuxième filtres élémentaires étant notés 12, respectivement 11. Le premier filtre élémentaire comporte un nombre pair de coefficients et le deuxième filtre élémentaire comporte un nombre impair de coefficients.

Ainsi qu'on l'a représenté en outre sur la figure 8d, chaque deuxième filtre élémentaire, le filtre élémentaire 11 de rang q=1 précédemment cité, peut à son tour être subdivisé par subdivision successive de rang supérieur q+1 en un premier, 112, et en un deuxième filtres élémentaires de rang q+1, noté 111, correspondant. Le premier, 112, et le deuxième, 111, filtres élémentaires de rang q+1, comprennent respectivement un nombre de coefficients pair et impair. Chaque premier respectivement deuxième filtre élémentaire, 12, 112, 1112, pour les rangs q successifs, et respectivement, 11, 111, 1111, pour les mêmes rangs, est destiné au traitement de $SB/2^q$ sous-bandes, où SB désigne le nombre de sous-bandes. Le processus peut être poursuivi pour des rangs q+1 supérieurs, tant que le deuxième filtre impair de rang supérieur est susceptible d'être à nouveau soumis au processus du subdivision. On notera bien sûr que dans un tel cas, le nombre SB de sous-bandes est égal à une puissance de 2.

Ainsi, la configuration du filtre prototype utilisé peut-elle être variable séquentiellement au rythme de transmission des blocs d'échantillons. Le filtre peut alors être utilisé tel quel ou au contraire commuté en diverses configurations de sous-filtres. Un tel mode opératoire permet d'effectuer une commutation au rythme des zones ou des blocs, cette commutation pouvant être commandée sur critère de codage de mouvement sur les blocs considérés lorsque les échantillons concernent des échantillons d'images vidéo, ou sur critère énergétique, par exemple lorsque le signal transmis est un signal vidéo- et/ou audionumérique, le critère de commutation pouvant également être utilisé pour la transmission des voies droite et gauche d'un son stéréophonique, lorsque le signal numérique d'entrée est un signal audio-numérique correspondant.

On comprendra que le nombre NF de coefficients du filtre du banc de filtre utilisé pour obtenir la propriété précitée doit être de longueur impaire et avantageusement vérifier la relation :

$$NF \ = \ 2SB - 1.$$

La technique précédemment décrite de création de deux filtres élémentaires à partir d'un filtre impair peut ainsi être mise en oeuvre successivement ainsi que représenté en figure 8d. On comprend ainsi que la mise en oeuvre d'un filtre PRMF comportant un nombre impair de coefficients contient en fait toutes les réalisations des filtres élémentaires correspondants.

En deuxième lieu, on observe que le coût des opérations pour la réalisation des fonctions élémentaires décrites en relation avec les figures précitées, tant dans le cas de la transformation inverse que dans le cas de la transformation directe, est identique. On constate ainsi que le nombre d'opérations nécessaires à la phase de reconstruction est strictement identique à celui de la phase de décomposition en sous-bandes ainsi que mentionné précédemment dans la description.

Une telle implantation sous forme de circuit intégré est ainsi facilitée par le caractère dual des différents modules constitutifs des circuits ou dispositifs de segmentation respectivement de reconstruction conformes à l'objet de la présente invention.

Ainsi, pour une réalisation de ce dispositif sous forme de circuit intégré, celui-ci pourra comporter, ainsi que représenté en figure 9a, au moins un module papillon, noté Modulel, présent dans une transformée de Fourier rapide FFT de taille SB, au moins un module papillon présent dans une transformée de Fourier rapide FFT de taille SB/2, ce module étant noté Module3 sur la figure 9a, et au moins un module de rotation élémentaire destiné à assurer l'interconnexion du module papillon de taille SB et du module papillon de taille SB/2 précité, ou de chacun de ces modules. On comprend que ce module rotation désigné par Module2 sur la figure 9a permet d'assurer la liaison entre le module papillon, Modulel, et module papillon, Module3. On comprend bien sûr que dans le cas d'un nombre de sous-bandes SB > 8, il est envisageable de réaliser l'interconnexion de plusieurs modules de taille SB/$2^q$ à des modules papillon de taille SB/$2^{q-1}$, si nécessaire.

Enfin, le circuit intégré conforme à l'objet de la présente invention comporte une pluralité de modules uniques tels que représentés en figures 9b et 9c désignés par Module 4a regroupant l'ensemble de ces modules uniques, ce module comportant au moins un module unique simplifié désigné par module 40a respectivement 40s et SB/2-1 modules uniques, notés modules 41a à 43a sur la figure 9b, ces modules étant destinés à assurer le préfiltrage des échantillons du signal numérique d'entrée, respectivement le postfiltrage des signaux de composantes en sous-bandes transformés. On rappelle que tous ces modules peuvent être réalisés à partir de réseaux de circuits multiplicateurs interconnectés de façon à réaliser les fonctions de transfert recherchées représentées en figures 7d et 8c. Sur les figures 9b et 9c, les notations $i_1$, $j_1$ et $i_1'$, $j_1'$ désignent des valeurs multiplicatives spécifiques à l'analyse respectivement à la synthèse.

On note que chaque module, tel que représenté en figures 9a, 9b et 9c comprend une entrée CI de commande d'activation/transparence reliée à un BUS de commande correspondant, ce qui permet sur commande de mise en transparence d'un ou plusieurs modules la transmission à l'identique des données à l'entrée du ou des modules considérés vers la sortie de ces derniers. Une telle mesure permet, dans le traitement d'image vidéo précédemment décrit par exemple, d'effectuer un traitement séparé des coefficients pairs ou impairs, les coefficients pairs pouvant être affectés à la première trame et les coefficients impairs à la deuxième trame de l'image vidéo. On note également que la commande est effectuée de préférence par adressage au niveau de chaque module ce qui permet bien entendu d'effectuer un traitement séparé ou non en trame (vertical). Le traitement horizontal peut alors permettre soit un traitement de signaux vidéo en noir et blanc sur les huit voies d'entrée, ou, avantageusement, sur les composantes de couleur des signaux vidéo d'image, les composantes rouge et bleu pouvant alors être traitées séparément en vue de créer soit des corrections de couleur soit des effets spéciaux. On note enfin que le choix de coefficients identiques pour des modules rendus ainsi identiques permet un traitement en parallèle des signaux d'entrée. Le ou les modules 2 correspondants peuvent alors être rendus soit transparents soit identiques.

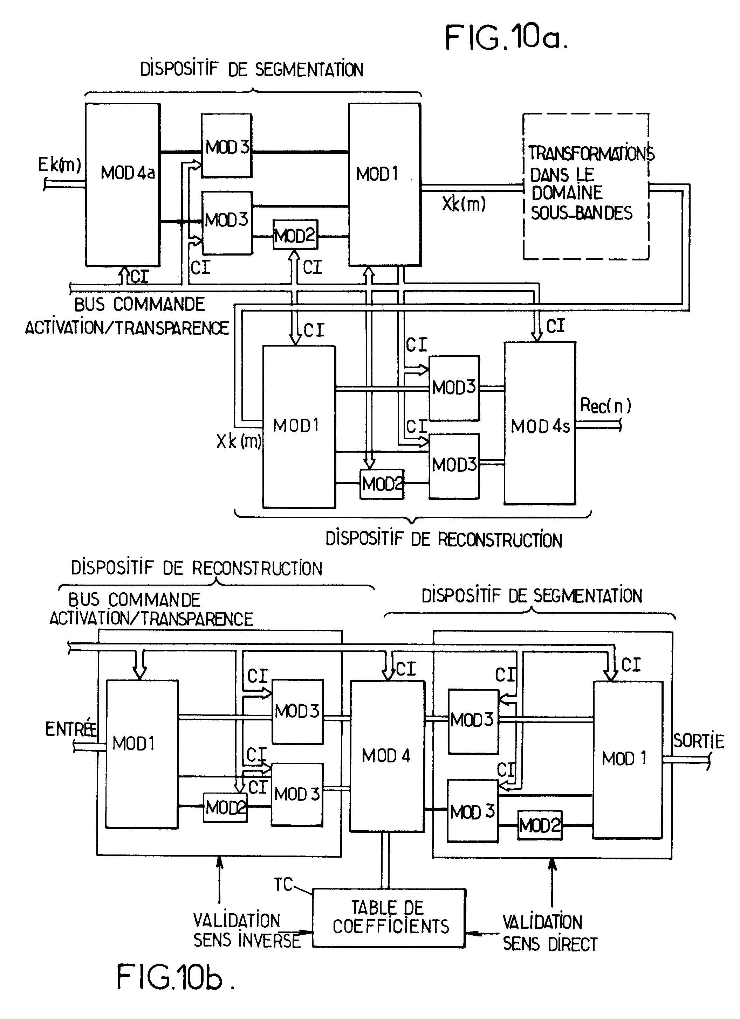

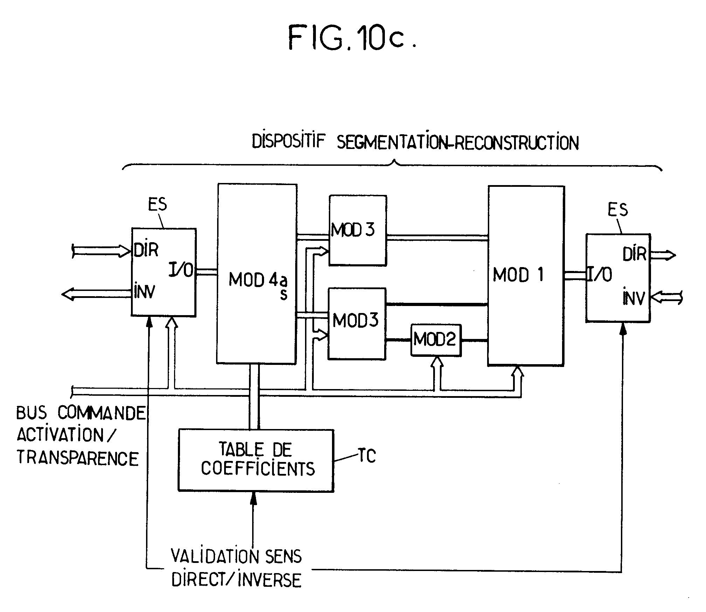

L'implantation des différents modules précités est resprésentée en figure 10a à 10c, le circuit intégré correspondant permettant alors de réaliser, soit un dispositif de segmentation conforme à l'objet de la présente invention, soit un dispositif de reconstruction en fonction du flux des données traitées constitutives du signal numérique d'entrée, et bien entendu des valeurs de coefficient mémorisées pour le traitement correspondant.

La figure 10a représente un schéma d'implantation dans lequel le dispositif de segmentation et le dispositif de reconstruction sont topographiquement séparés, par une zone de traitement ou de transformation des signaux en sous-bandes, laquelle ne fait pas partie de l'objet de la présente invention. Les modules 4a et 4s, relatifs à l'analyse ou segmentation respectivement à la synthèse ou reconstruction correspondent à ceux décrits en figure 9b ou 9c, respectivement. En figure 10b, le dispositif de segmentation et le dispositif de reconstruction sont toujours topographiquement séparés mais réunis par un seul et même Module4, lequel peut intégrer, pour le module unique simplifié, deux blocs mémoires commutables, de façon à réaliser, sur commutation, l'un ou l'autre des Module 4a, Module4s, représenté en figure 9b ou 9c. Une table des coefficients TC permet, sur validiation du sens direct respectivement inverse, la mémorisation des coefficients multiplicatifs des circuits multiplicateurs du réseau constitutif des différents modules implantés, le dispositif non validé de segmentation ou de reconstruction étant rendu inactif.

La figure 10c enfin correspond à un schéma d'implantation dans lequel le dispositif de segmentation, respectivement de reconstruction, sont topographiquement confondus. Dans ce cas, les ports d'entrée des échantillons Ek(m) respectivement des composantes en sous-bandes Xk(m), ou réciproquement, sont complétés chacuns par un circuit d'entrée-sortie ES de type inverseur, commandé par un signal de validation sens direct, segmentation, sens inverse, reconstruction. On comprend que dans le cas de la figure 10c le circuit intégré unique est parcouru par un flux de données dans un sens différent selon le type de transformation segmentation ou reconstruction effectivement validé.

En particulier, selon le sens de la transformation directe ou inverse envisagée, le Module 4 peut être alimenté par une table de coefficients particuliers, défini précédem- ment dans la description pour la segmentation, respectivement pour la reconstruction. Le Module 4 joue le rôle soit du Module 4a, soit du Module 4s.

On a ainsi décrit un procédé et un dispositif de segmentation d'un signal numérique en sous-bandes, respectivement de reconstruction de ce signal, particulièrement performant dans la mesure où une suite de processus de traitements successifs ont permis la mise en évidence de processus de traitement et de modules de traitement duaux, ce qui permet, à partir d'un seul et même circuit intégré dans lequel sont implantés les modules correspondants, d'effectuer, soit le traitement de segmentation, soit le traitement de reconstruction en temps réel, ou en temps partagé.

En outre, on indique également que la réalisation précédemment décrite sous forme de circuit intégré mettant en oeuvre un algorithme rapide de traitement peut être généralisée aux bancs de filtres MOT. Dans ce cas, le coût en opérations d'additions et soustractions ainsi que les tailles des mémoires utilisées restent identiques à celui du mode de réalisation à partir de bancs de filtres PRMF, tout en offrant cependant, d'une part, une plus grande souplesse dans le choix des coefficients des différents modules, lesquels ne sont pas figés, et sont donc ajustables, en raison du degré de liberté supplémentaire dont bénéficient les filtres de la famille MOT et, d'autre part, une meilleure sélectivité en fréquence. Une pluralité de tables de consultation élémentaires contenant différentes valeurs ou différents groupes de valeurs de ces coefficients peut alors être utilisée.

## Revendications

**1)** Procédé de segmentation en sous-bandes d'un signal numérique, constitué par une suite d'échantillons numériques, du type consistant à soumettre chaque échantillon à un traitement en parallèle sur une pluralité de voies de façon à décomposer ce signal numérique en un nombre correspondant de sous-bandes, ce traitement, pour chaque sous-bande, consistant à effectuer un filtrage numérique en sous-bande au moyen d'un filtrage prototype modulé par une fonction périodique et un sous-échantillonnage par le nombre SB de sous-bandes, pour délivrer un signal en sous-bandes $X_k$ pour chaque voie de rang k correspondant, caractérisé en ce que, pour une succession de blocs d'échantillons formés par SB échantillons et constituant le signal numérique, ledit procédé consiste à effectuer, au moyen d'un filtrage prototype de type passe-bas à deux composantes, une composante symétrique et une composante antisymétrique, chacune modulée par une fonction périodique, en combinaison, un filtrage et un traitement par transformée fréquentielle du signal numérique, ce filtrage correspondant à un filtrage polyphase modifié, ce qui permet de délivrer un signal en sous-bande $X_k$ pour chaque voie de rang k correspondant.

**2)** Procédé selon la revendication 1, caractérisé en ce que ledit procédé consiste à effectuer :
- un préfiltrage du signal numérique d'entrée, ce préfiltrage correspondant à un filtrage polyphase modifié appliqué à chaque bloc d'échantillons, pour obtenir un signal pré-filtré,
- un traitement par transformée fréquentielle inverse du signal préfiltré, de façon à délivrer ledit signal en sous-bande $X_k$ correspondant.

**3)** Procédé selon la revendication 1, caractérisé en ce que ledit procédé consiste à effectuer :
- un traitement par transformée fréquentielle directe dudit signal numérique d'entrée, pour obtenir un signal transformé,
- un post-filtrage dudit signal transformé, ce post-filtrage correspondant à un filtrage poplyphase modifié, ce qui permet de délivrer un signal en sous-bande $X_k$ pour chaque voie de rang k correspondant.

**4)** Procédé selon l'une des revendications 1 à 3, caractérisé en ce que celui-ci consiste en outre à soumettre l'un au moins des signaux en sous-bande $X_k$ délivré audit traitement en parallèle sur une pluralité de voies, de façon à décomposer ledit signal en sous-bandes $X_k$ en signaux en sous-bandes élémentaires $X_{k1}$, avec $1 \in [0, SBE]$, SBE désignant le nombre de sous-bandes élémentaires, ledit traitement en parallèle pouvant être réappliqué sur au moins une des sous-bandes élémentaires pour engendrer des sous-bandes élémentaires de rang successif supérieur correspondant.

**5)** Procédé de reconstruction d'un signal numérique en sous-bandes, ce signal correspondant à une pluralité de signaux sous-bandes $X_k$, délivrés en parallèle suite à une segmentation en sous-bandes d'un signal numérique E(n), ce procédé de reconstruction étant du type consistant à soumettre chaque signal en sous-bandes $X_k$ à un traitement en parallèle comportant un suréchantillonnage par le nombre de signaux en sous-bande et un filtrage numérique au moyen d'un filtrage prototype de type passe-bas modulé par une fonction périodique pour délivrer une composante de sous-bande $R_k$ de signal numérique reconstruit puis une sommation synchrone des composantes de sous-bandes de signal numérique reconstruit pour engendrer le signal numérique reconstruit Rec(n), caractérisé en ce que pour une pluralité de signaux en sous-bande $X_k$, ce procédé consiste à effectuer, au moyen d'un filtrage prototype de type passe-bas à deux composantes, une composante symétrique et une composante antisymétrique, chacune modulée par une fonction périodique, en combinaison, un filtrage et un traitement par transformée fréquentielle des signaux en sous-bandes, ce traitement de filtrage correspondant à un traitement de filtrage de type polyphase modifié, ce qui permet de délivrer ledit signal numérique reconstruit.

6) Procédé selon la revendication 5, caractérisé en ce que ledit procédé consiste à effectuer :
- un traitement par transformée fréquentielle directe, pour délivrer à partir de chaque signal numérique en sous-bande, une pluralité de signaux numériques transformés, et
- un traitement de post-filtrage de type polyphase modifié desdits signaux numériques transformés pour délivrer des signaux numériques transformés postfiltrés permettant de délivrer ledit signal numérique reconstruit.

7) Procédé selon la revendication 5, caractérisé en ce que celui-ci consiste à effectuer :
- un traitement de préfiltrage de type polyphase modifié desdits signaux numériques en sous-bande $X_k$, pour délivrer une pluralité de signaux numériques en sous-bandes pré-filtrés, et
- un traitement par transformée fréquentielle inverse desdits signaux numériques en sous-bandes préfiltrés pour délivrer des signaux numériques transformés permettant de délivrer ledit signal numérique reconstruit.

8) Procédé selon l'une des revendications 5 à 7, caractérisé en ce que pour une pluralité de signaux en sous-bandes dont l'un au moins est sous forme d'au moins une sous-bande élémentaire de rang p déterminé, ledit procédé consiste à soumettre ledit signal en sous-bande élémentaire de rang considéré au procédé de reconstruction pour engendrer par reconstruction un signal en sous-bande élémentaire de rang inférieur, successivement, puis le signal en sous-bande $X_k$ correspondant.

9) Dispositif de segmentation en sous-bandes d'un signal numérique, constitué par une suite d'échantillons numériques comprenant une pluralité SB de voies en parallèle recevant chacune lesdits échantillons E(n), caractérisé en ce que pour une succession de blocs d'échantillons formés de SB échantillons, ledit dispositif comprend en cascade,
- des moyens de préfiltrage du signal numérique d'entrée, ce préfiltrage correspondant à un filtrage polyphase modifié appliqué à chaque bloc d'échantillons, pour délivrer des composantes de signaux préfiltrés,
- des moyens de traitement par transformée fréquentielle inverse de dimension SB desdites composantes de signaux préfiltrés, permettant de délivrer lesdits signaux en sous-bande $X_k$.

10) Dispositif de reconstruction d'un signal numérique en sous-bandes, ce signal correspondant à une pluralité SB de signaux en sous-bandes $X_k$, $k \in [0,SB-1]$ délivrés en parallèle, à la suite d'une segmentation en sous-bandes d'un signal numérique E(n) sur une pluralité SB de voies en parallèle, caractérisées en ce que pour une pluralité de SB signaux en sous-bande, ledit dispositif comprend en cascade :
- des moyens de traitement desdits signaux en sous-bande par transformée fréquentielle directe,
- des moyens de post-filtrage, ce post-filtrage correspondant à un filtrage polyphase modifié, permettant de délivrer le signal numérique reconstruit.

11) Dispositif selon la revendication 9 ou 10, caractérisé en ce que lesdits moyens de préfiltrage et moyens de traitement par transformée fréquentielle inverse respectivement moyens de traitement par transformée fréquentielle directe et moyens de post-filtrage sont formés par des bancs de filtres MOT présentant une fonction de transfert de segmentation

$$hk(n) = 1/2 \cdot [\, hs(n).Ck(n) - ha(n).Ck(NF - 1 - n) \,]$$

respectivement de reconstruction

$$gk(n) = 1/2 \cdot [\, hs(n).Ck(NF - 1 - n) + ha(n).Ck(n) \,].$$

où hs(n) et ha(n) représentent respectivement les fonctions de transfert des composantes symétrique et antisymétrique, par rapport au point milieu des filtres, de la fonction de transfert h(n) du filtre prototype, lesdites fonctions périodiques de modulation étant formées par des modules présentant une fonction de transfert

$$Ck(n) = 2.Cos \left[ \frac{\pi.(2k+1).(2n-NF+1-SB)}{4\ SB} \right]$$

pour le dispositif de segmentation, respectivement

$$Ck(NF-1-n) = 2.\cos\left[\frac{\pi.(2k+1).(2n-NF+1+SB)}{4\ SB}\right]$$

pour le dispositif de reconstruction, fonctions de transfert dans lesquelles :

n  représente l'indice courant,

k  représente le rang de la sous-bande considérée,

NF  représente le nombre de coefficients du banc de filtres utilisé,

SB  représente le nombre de sous-bandes dans lequel le processus de segmentation reconstruction est effectué par ledit dispositif,

h(n)  représente la réponse impulsionnelle du filtre prototype,

hs(n)  représente la réponse impulsionnelle de la composante symétrique de h(n),

ha(n)  représente la réponse impulsionnelle de la composante antisymétrique de h(n).

**12)** Dispositif selon la revendication 11, caractérisé en ce que lesdits moyens de préfiltrage et de traitement par transformée fréquentielle inverse respectivement moyens de traitement par transformée fréquentielle directe et moyens de post-filtrage sont formés par des bancs de filtre PRMF présentant une fonction de transfert de segmentation h(n).Ck(n), respectivement de reconstruction h(n).Dk(n), où h(n) représente la fonction de transfert du filtre prototype, h(n) = hs(n) la composante antisymétrique ha(n) étant choisie nulle, ha(n)=O, lesdites fonctions périodiques de modulation étant formées par des modules présentant une fonction de transfert

$$Ck(n) = 2.\cos\left(\frac{\pi.(2k+1).(2n-NF+1-SB)}{4.SB}\right)$$

pour le dispositif de segmentation, respectivement

$$Ck(NF-1-n) = Dk(n) = 2.\cos\left(\frac{\pi.(2k+1).(2n-NF+1+SB)}{4.SB}\right)$$

pour le dispositif de reconstruction.

**13)** Dispositif selon la revendication 12, caractérisé en ce que pour un banc de filtres PRMF adapté au codage à réduction de débit, comportant un nombre de coefficients NF $\leq$ 2.SB, ledit banc de filtres est constitué soit par un nombre impair NF de coefficients du filtre, NF = 2.SB-1, la fonction de transfert dudit filtre prototype vérifiant la relation :

$$h(n) = \frac{1}{\sqrt{2.SB}} \cdot \sin\frac{(n+1).\pi}{2.SB}, \qquad \text{avec } n\in[0,2.SB-2],$$

soit par un nombre pair NF de coefficients du filtre NF = 2.SB, la fonction de transfert dudit filtre prototype vérifiant la relation :

$$h(n) = \frac{1}{\sqrt{2.SB}} \cdot \sin\frac{(n+0,5).\pi}{2.SB}, \qquad \text{avec } n\in[0,2.SB-1].$$

**14)** Dispositif selon l'une des revendications 9 ou 10, et 13, caractérisé en ce que lesdits moyens de préfiltrage du signal numérique d'entrée, respectivement de post-filtrage, permettant de délivrer le signal numérique reconstruit sont formés, pour un nombre NF pair respectivement impair de coefficients du filtre, par un module en treillis dont la fonction de transfert vérifie la relation:

$$S_i(m) = a_i.E_i(m-1) - b_i - E_{SB-i-2\theta}(m-1)$$
$$S_{SB-i-2\theta}(m) = a_i.E_{SB-i-2\theta}(m) + b_i.E_i(m)$$

pour i rang de l'échantillon Ei dans un bloc d'échantillons de taille SB, tel que $i\in[0,\frac{SB}{2}-1]$ pour NF pair,

repectivement $i\in[1,\frac{SB}{2}-1]$ pour NF impair, avec $\theta=0$ pour NF, impair et $\theta=0,5$ pour NF pair, ledit module en treillis vérifiant d'autre part la relation

$$S_o(m) = a_o.E_o(m-1) \qquad \text{pour } i = 0 \text{ et}$$
$$S_{SB/2}(m) = b_{SB/2}.E_{SB/2}(m) \qquad \text{pour } i = \frac{SB}{2} \text{ pour NF impair,}$$

relations dans lesquelles $a_i$, $b_i$ sont des valeurs numériques déterminées affectées au rang i et reliées aux coefficients h(n) de chaque échantillon, m désignant l'indice du bloc courant de largeur SB.

**15)** Dispositif selon l'une des revendications 9 ou 10 et 13, 14, caractérisé en ce que lesdits moyens de traitement par transformée fréquentielle inverse respectivement directe contiennent des modules rotation, respectivement en premier et en dernier étage montés en cascade avec un sous-module d'entrée respectivement de sortie de la transformée fréquentielle, lesdits modules rotation présentant une fonction de transfert vérifiant la relation :

$$e_i(m) = c_i.S_i(m) - d_i - S_{SB - i - 2\theta}(m)$$
$$f_i(m) = c_i.S_{SB - i - 2\theta}(m) + d_i.S_i(m)$$

lesdits modules en treillis respectivement modules de pré- et postfiltrage et modules rotation formant module d'entrée respectivement de sortie de la transformée fréquentielle étant montés en cascade.

**16)** Dispositif selon la revendication 15, caractérisée en ce que lesdits modules rotation et modules en treillis en cascade sont remplacés par un module unique ledit module unique comportant

- un sous-module treillis dont la fonction de transfert vérifie la relation :

$$E_{i1}(m) = [ (a_ic_i - b_id_i)E_i(m) - (a_id_i + b_ic_i)E_{SB - i - 2\theta}(m) ]$$
$$F_{i1}(m) = [ (a_id_i + b_ic_i)E_i(m) + (a_ic_i - b_id_i)E_{SB - i - 2\theta}(m) ]$$

- un sous-module treillis en parallèle sur ledit sous-module treillis direct, dont la fonction de transfert vérifie la relation :

$$E_{i2}(m) = [ V_i(m) - V_i(m + 1) ] (\alpha.c_i)$$
$$F_{i2}(m) = [ V_i(m) - V_i(m + 1) ] (\alpha - d_i)$$

avec

$$V_i(m + 1) = \frac{a}{\alpha}_i.E_i(m) - \frac{b}{\alpha}_i.E_{SB - i - 2\theta}(m)$$

le signal résultant délivré par le module unique étant de la forme $e_i(m) = E_{i1}(m) + E_{i2}(m)$, $f_i(m) = F_{i1}(m)$ + $F_{i2}(m)$, relations dans lesquelles a est une valeur déterminée pour chaque $i \in [0, \frac{SB}{2} - 1]$ pour NF pair et $i \in [1, \frac{SB}{2} - 1]$ pour NF impair, le module unique étant réduit pour NF impair et i=0 et $i = \frac{SB}{2}$ à un module simplifié vérifiant la relation:

$$e_0(m) = a_0.c_0.E_0(m - 1) b_0 - c_0 - E_{SB/2}(m)$$
$$f_0(m) = a_0.c_0.E_0(m - 1) - b_0.c_0.E_{SB/2}(m)$$

**17)** Dispositif selon la revendication 16, caractérisé en ce que pour une normalisation optimale, les expressions $a_i. c_i - b_i.d_i$ et $a_i.d_i + b_i.c_i$ sont prises égales à 1/2 ou -1/2.

**18)** Dispositif selon la revendication 16, caractérisé en ce que lesdits modules uniques sont agencés en parallèle de façon à constituer un étage de préfiltrage de l'ensemble des échantillons respectivement étage de post-filtrage des composantes de sous-bandes, chaque étage comportant pour un nombre de coefficients de filtre impair

- un module unique simplifié ;

- une pluralité de $\frac{SB}{2}$ - 1 modules uniques, chaque étage de préfiltrage respectivement de post-filtrage ainsi constitué étant suivi, respectivement précédé, d'un étage de transformée fréquentielle de type FFT paire.

**19)** Dispositif selon la revendication 16, caractérisé en ce que lesdits modules uniques sont agencés en parallèle de façon à constituer un étage de préfiltrage de l'ensemble des échantillons respectivement étage de post-filtrage des composantes de sous-bandes, chaque étage comportant pour un nombre de coefficients de filtre pair :

- une pluralité de $\frac{SB}{2}$ modules uniques, chaque étage de préfiltrage respectivement de post-filtrage ainsi constitué étant suivi, respectivement précédé, d'un étage de transformée fréquentielle de type FFT impaire.

**20)** Dispositif selon la revendication 18 ou 19, caractérisé en ce que, pour une réalisation de ce dispositif sous forme de circuit intégré, celui-ci comporte :

- au moins un module papillon de taille SB,
- au moins un module papillon de taille SB/2,
- au moins un module de rotation élémentaire destiné à assurer l'interconnexion dudit au moins un module papillon de taille SB et d'un au moins des modules papillon de taille SB/2,
- une pluralité de modules uniques comportant au moins un module unique simplifié et destinés à assurer le préfil- trage des échantillons du signal numérique d'entrée respectivement le post-filtrage des signaux de composantes en sous-bandes transformées.

**21)** Dispositif selon la revendication 20, caractérisé en ce que pour SB=8 et NF=15 et dans une application de segmentation-reconstruction de signaux numériques d'images, ledit circuit intégré comprend :

- un module papillon de taille huit,

- un module de rotation élémentaire,
- deux modules papillons de taille quatre, l'un desdits modules papillons de taille quatre étant interconnecté audit module papillon de taille huit par l'intermédiaire dudit module rotation élémentaire,
- une pluralité de modules uniques formée par un module unique simplifié et trois modules uniques, lesdits modules uniques étant interconnectés auxdits modules papillons de taille quatre.

**22)** Dispositif selon la revendication 21, caractérisé en ce que celui-ci comporte en outre une table de consultation des valeurs des coefficients desdits modules, ce qui permet l'utilisation dudit circuit intégré, selon la validation des valeurs desdits coefficients pour la segmentation respectivement la reconstruction.

**23)** Dispositif selon la revendication 22, caractérisé en ce que les valeurs desdits coefficients étant ajustables, ladite table de consultation est constituée par une pluralité de tables de consultation élémentaires.

**24)** Dispositif selon la revendication 12 ou 21, caractérisé en ce que ledit filtre prototype comporte un nombre impair de coefficients, ce filtre étant subdivisé selon une première subdivision, de rang q, (q=1), en un premier et en un deuxième filtre élémentaire, le premier filtre élémentaire comportant un nombre pair de coefficients et le deuxième filtre élémentaire comportant un nombre impair de coefficients, chaque deuxième filtre élémentaire de rang q pouvant à son tour être subdivisé par subdivision successive de rang supérieur q+1 en un premier et en un deuxième filtre élémentaire de rang q+1 correspondant comprenant respectivement un nombre de coefficients pair et impair, chaque premier respectivement deuxième filtre élémentaire de rang q étant destiné au traitement de $SB/2^q$ sous-bandes, où SB désigne le nombre de sous-bandes.

**25)** Dispositif selon l'une des revendications 20 à 24, caractérisé en ce que chaque module comprend une entrée de commande d'activation/transparence du module correspondant, chaque module permettant, sur commande de mise en transparence, la transmission à l'identique des entrées dudit module vers ses sorties.

—— SIGNAL NUMÉRIQUE SOURCE

—— SIGNAL RECONSTRUIT APRÈS CONSERVATION DU SEUL COEFFICIENT
CONTINU DANS LE DOMAINE DCT

TRANSITION ABRUPTES
MARQUÉES ENTRE LES
VALEURS MOYENNES DE
BLOCS CONSÉCUTIFS

BLOC m    BLOC m+1    BLOC m+2    BLOC m+3

FIG.1a. (ART ANTÉRIEUR)

( DÉPLACEMENT FENÊTRE D'UNE LONGUEUR DE BLOC )

BLOC m    BLOC m+1    BLOC m+2    BLOC m+3

FENÊTRE DE FILTRAGE TYPE DCT (1 SUR LE BLOC. 0 AILLEURS )

FIG.1b (ART ANTÉRIEUR )

(DÉPLACEMENT FENÊTRE D'UNE LONGUEUR DE BLOC)

BLOC m   BLOC m+1   BLOC m+2   BLOC m+3

FIG.1c. (ART ANTÉRIEUR)

SOUS_ÉCHANTILLONNAGE PAR SB

SUR_ÉCHANTILLONNAGE PAR SB

FIG.1d (ART ANTÉRIEUR)

E(n)

1000
(1)FILTRAGE
(2)POLYPHASE MODIFIÉ
(2)TRANSFORMÉE
(1)FRÉQUENTIELLE

X0
Xk
XSB_1

2000
(1)TRANSFORMÉE
(2)FRÉQUENTIELLE
(2)FILTRAGE
(1)POLYPHASE MODIFIÉ

Rec(n)

SEGMENTATION   FIG.2a.   RECONSTRUCTION

1001

E(n) → | (1) FILTRAGE POLYPHASE MODIFIÉ  (2) TRANSFORMÉE FRÉQUENTIELLE INVERSE |

○ X0 ○
○ Xk ○
○ XSB_1 ○

2001

| (1) TRANSFORMÉE FRÉQUENTIELLE DIRECTE  (2) FILTRAGE POLYPHASE MODIFIÉ | → Rec(n)

SEGMENTATION

RECONSTRUCTION

## FIG.2b.

E(n) →

•X0
•X1
1000
•Xk →
•XSB_2
•XSB_1

SOUS_BANDES

1000

•X0
•Xk1
•Xkl
•XkSB_2
•XkSB_1

SOUS_BANDES ÉLÉMENTAIRES

## FIG.3a.

EP 0 595 710 A1

FIG.2c

FIG.3b.

ÉTAGE DE PRÉFILTRAGE

ÉTAGE
TRANSFORMÉE FRÉQUENTIELLE
INVERSE

$E(mSB+o)$

$S_0(m)$

$X_0(m)$

$E(mSB+s)$

$E(mSB+SB-1)$

$S_{SB-1}(m)$

$X_{SB-1}(m)$

1

2

## FIG.4.

ÉTAGE DE
TRANSFORMÉE FRÉQUENTIELLE
DIRECTE

ÉTAGE DE
POST-FILTRAGE

$X_0(m)$

$Rec(mSB+o)$

$Rec(mSB+s)$

$X_{SB-1}(m)$

$Rec(mSB+SB\_1)$

3

4

## FIG.5.

hk(n)

E(n) •————[ h(n).Ck(n) ]—[↓SB]—• Xk

SEGMENTATION

gk(n)

Xk •—[↑SB]—[ h(n).Dk(n) ]—————• Rk >(+) Rec(n)
                                        5

RECONSTRUCTION

## FIG.6a.

NF PAIR POUR $i \in \left[0, \dfrac{SB}{2} - 1\right]$

$E_i(m)$ —— $a_i$ —— •—— [ MEM ] —— • $S_i(m)$

$-b_i$

$b_i$

$E_{SB\_i-1}(m)$ —— $a_i$ —— •—————— • $S_{SB\_i-1}(m)$

NF IMPAIR POUR $i \in \left[1, \dfrac{SB}{2} - 1\right]$

$E_i(m)$ —— $a_i$ —— •—— [ MEM ] —— • $S_i(m)$

$-b_i$

$b_i$

$E_{SB\_i}(m)$ —— $a_i$ —— •—————— • $S_{SB\_i}(m)$

ET POUR $i = 0$ ET $i = \dfrac{SB}{2}$ (CAS NF IMPAIR):

$E_0(m)$ —— $a_0$ —— •—— [ MEM ] —— • $S_0(m)$

$E_{SB/2}(m)$ —— $b_{SB/2}$ —— •—————— • $S_{SB/2}(m)$

## FIG.6b.

MODULE EN TREILLIS    MODULE DE ROTATION DE
TRANSFORMÉE INVERSE

$E_i(m)$    $a_i$    $S_i(m+1)$    MEM    $S_i(m)$    $c_i$    $e_i(m)$

$b_i$    $d_i$

$b_i$    $SSB\_i\_2\Theta(m)$    $d_i$

$E_{SB\_i\_2\Theta(m)}$    $a_i$    $c_i$    $f_i(m)$

FIG. 6 c.

MODULE UNIQUE    $e_i(m) = Ei1(m) + Ei2(m)$

$a_i c_i\_b_i d_i$    $Ei1(m)$    $Ei1(m)$

$E_{i(m)}$    $a_i d_i + b_i c_i$    $Ei2(m)$

$a_i d_i + b_i c_i$    $a_i/\alpha$    $V_i(m+1)$    $c_i \cdot \alpha$

$b_i/\alpha$    MEM    $d_i \cdot \alpha$    $Fi2(m)$

$E_{SB\_i\_2\Theta(m)}$    $V_i(m)$    $Fi1(m)$

$a_i c_i\_b_i d_i$    $Fi1(m)$

$f_i(m) = Fi1(m) + Fi2(m)$

FIG. 6d.

MODULE UNIQUE SIMPLIFIÉ

$E_O(m)$    $S_O(m+1)$    MEM    $S_O(m)$    $e_O(m)$

$a_O c_O$

$b_O c_O$

$E_{SB}/2(m)$    $f_O(m)$

$S_{SB}/2(m)$

FIG. 6e.

EP 0 595 710 A1

**FIG.7a.**

GLISSEMENT DU FILTRE DE 8 PIXELS A DROITE

hm14  hm13  hm12  hm11  hm10  hm9  hm8

S3(m+1)
S2(m+1)
S1(m+1)
S0(m+1)

P3(m+1)  P2(m+1)  P1(m+1)  P0(m+1)  P_1(m+1)  P_2(m+1)  P_3(m+1)

hm14  hm13  hm12  hm11  hm10  hm9  hm8  hm7  hm6  hm5  hm4  hm3  hm2  hm1  hm0

S3(m)
S2(m)
S1(m)
S0(m)
S4=P_4(m)
S5(m)
S6(m)
S7(m)

P3(m)  P2(m)  P1(m)  P0(m)   P_1(m) P_2(m) P_3(m)     P_5(m)  P_6(m) P_7(m)     P7(m)  P6(m)  P5(m)

E5(m-1) E6(m-1) E7(m-1) E0(m-1) E1(m-1) E2(m-1) E3(m-1) E4(m) E5(m) E6(m) E7(m) E0(m)  E1(m) E2(m) E3(m)

| 4 | 5 | 6 | 7 | 0 | 1 | 2 | 3 | 4 | 5 | 6 | 7 | 0 | 1 | 2 | 3 |

◄────── BLOC m-1 ──────►◄─────────── BLOC m ───────────►
(BLOC PRÉCÉDENT)              (BLOC COURANT)

**FIG.7f.**

ZONE 89 ── ZONE j  ZOi+1,j  ZONE 0 ZONE 89  ZOi,j+1  ZONE j+1  ZONE j  ZOi,j  ZONE 0

PRÉSENTATION
DES VECTEURS
D'ENTRÉE

Y7────Y0                    Y7────Y0 Y7────Y0

BANDE i+1                        BANDE i

FIG.7b.

FIG.7c.

FIG. 7d.

FIG.7e.

BANDE i

ZO$_{i,j}$

RESULTATS DE CALCULS X

BLOC MEMOIRE
Vx$_{b,t(i,j+1)}$

OPERANDES DE CALCULS

ZO$_{i,j+1}$

RESULTATS DE CALCULS Y

(STOCKAGE) M$_2$

BLOC MEMOIRE
Vy$_{a,t(i+1,j)}$

— M$_1$

OPERANDES DE CALCULS

FIG.7g.

BANDE i+1

ZO$_{i+1,j}$

FIG.8a.

FIG.8b.

FIG. 8 c.

1 ——— FILTRE IMPAIR A NF COEFFICIENTS_SB SOUS_BANDES

RANG q=1

11

FILTRE IMPAIR POUR SB/2
SOUS_BANDES

12

FILTRE PAIR POUR SB/2
SOUS_BANDES

111

FILTRE IMPAIR
SB/4 SOUS_BANDES

112

FILTRE PAIR
SB/4 SOUS_BANDES

RANG q

1111

FILTRE IMPAIR
SB/8 Ss Bds

1112

FILTRE PAIR
SB/8 Ss Bds

RANG q+1

ITÉRATION DU
PROCESSUS

FIG.8d.

FIG.9a.

FIG.9b.

FIG.9c.

MODULE 40a
MODULE 41a
MODULE 42a
MODULE 43a

MODULE 40s
MODULE 41s
MODULE 42s
MODULE 43s

CI    MODULE 4a    TABLE COEFFICIENTS

CI    MODULE 4s    TABLE COEFFICIENTS

EP 0 595 710 A1

# FIG.10a.

**DISPOSITIF DE SEGMENTATION**

Ek(m)

MOD 4a — MOD 3 — MOD 1 — Xk(m)

TRANSFORMATIONS DANS LE DOMAINE SOUS-BANDES

MOD 3 — MOD 2

CI — CI — CI

BUS COMMANDE ACTIVATION/TRANSPARENCE

CI — CI — CI

MOD 1 — Xk(m) — MOD 3 — MOD 4s — Rec(n)

CI — MOD 2 — MOD 3

**DISPOSITIF DE RECONSTRUCTION**

**DISPOSITIF DE RECONSTRUCTION**

**DISPOSITIF DE SEGMENTATION**

BUS COMMANDE ACTIVATION/TRANSPARENCE

CI — CI — CI

ENTRÉE — MOD 1 — MOD 3 — MOD 4 — MOD 3 — MOD 1 — SORTIE

CI — CI — CI

MOD 2 — MOD 3 — MOD 3 — MOD 2

VALIDATION SENS INVERSE

TC — TABLE DE COEFFICIENTS

VALIDATION SENS DIRECT

# FIG.10b.

# FIG.10c.

DISPOSITIF SEGMENTATION-RECONSTRUCTION

BUS COMMANDE
ACTIVATION /
TRANSPARENCE

TABLE DE COEFFICIENTS — TC

VALIDATION SENS
DIRECT/INVERSE

**Office européen**

**des brevets**

**RAPPORT DE RECHERCHE EUROPEENNE**

Numero de la demande

EP 93 40 2625

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| Y | CROCHIERE ET AL 'MULTIRATE DIGITAL SIGNAL PROCESSING' 1983 , PRENTICE HALL , ENGLEWOOD CLIFFS | 1,5 | H03H17/02 |
| A | * page 303, ligne 1 - page 316, ligne 11; figures 7.11-7.18 * | 9,10 | |
| | --- | | |
| Y | IEEE TRANSACTIONS ON SIGNAL PROCESSING vol. 40, no. 4 , Avril 1992 , NEW YORK, US pages 770 - 783 XP301406 KOILPILLAI ET AL 'COSINE-MODULATED FIR FILTER BANKS SATISFYING PERFECT RECONSTRUCTION' ABRÉGÉ | 1,5 | |
| A | * page 770, colonne 1, ligne 23 - page 777, colonne 1, ligne 3; figures 1-3 * | 9,10 | |
| | --- | | |
| A | IEEE INTERNATIONAL SYMPOSIUM ON CIRCUITS AND SYSTEMS; VOL 5, 11 JUIN 1991, SINGAPORE; P2753-2756; HARRIS et al: MODIFIED POLYPHASE FILTER STRUCTURE FOR COMPUTING INTERPOLATED ... * le document en entier * | 1,5,9,10 | |

**DOMAINES TECHNIQUES RECHERCHES (Int.Cl.5)**

H03H

Le présent rapport a été établi pour toutes les revendications

| Lieu de la recherche | Date d'achèvement de la recherche | Examinateur |
|---|---|---|
| LA HAYE | 4 Février 1994 | Coppieters, C |